# EUROPEAN PATENT APPLICATION

(11) **EP 4 560 705 A1**
(43) Date of publication of application: **28.05.2025**
(21) Application number: 23211619.4
(22) Date of filing: 22.11.2023
(51) Int. Cl.: H01L 25/075, H01L 33/62, G02F 1/1333, H01L 25/16, H10K 59/131, H10K 59/18

(54) **DISPLAY DEVICE**

(71) Applicant: LG Display Co., Ltd., Seoul 07336 (KR)
(72) Inventor: KIM, JeeHun, 10845 245, LG-ro, Wollong-Myeon, Paju-si, Gyeonggi-do, 10845 (KR); JEONG, Hyeran, 10845 245, LG-ro, Wollong-Myeon, Paju-si, Gyeonggi-do, 10845 (KR); BAE, Sungeun, 10845 245, LG-ro, Wollong-Myeon, Paju-si, Gyeonggi-do, 10845 (KR); LEE, Hyoseob, 10845 245, LG-ro, Wollong-Myeon, Paju-si, Gyeonggi-do, 10845 (KR)
(74) Representative: Wellburn, Daniel

(57) **Abstract**

A display device includes a substrate on which a plurality of light-emitting elements is disposed; a transistor on the substrate; a plurality of signal lines on the substrate; a plurality of link lines below the substrate; and a plurality of upper pads on the substrate and connected to the plurality of signal lines, in which the plurality of upper pads is disposed to overlap with at least one of the plurality of signal lines and the plurality of transistors. Therefore, it is possible to implement the high-resolution display device with zero bezel by reducing the bezel area of the display device.

## Description

### BACKGROUND

### Field of the Disclosure

The present disclosure relates to a display device, and more particularly, to a display device with a reduced bezel area.

### Description of the Background

As display devices used for a monitor of a computer, a TV set, a mobile phone, and the like, there are an organic light-emitting display (OLED) configured to autonomously emit, and a liquid crystal display (LCD) that requires a separate light source.

The range of application of the display devices is diversified from the monitor of the computer and the TV set to personal mobile devices, and studies are being conducted on the display devices having wide display areas and having reduced volumes and weights.

In addition, recently, a display device including a(n inorganic) light-emitting diode (LED), for example a microLED, has attracted attention as a next-generation display device. Because the LED is made of an inorganic material instead of an organic material, the LED is more reliable and has a longer lifespan than a liquid crystal display device or an organic light-emitting display device.

Further, the LED may be quickly turned on or off, have excellent luminous efficiency, high impact resistance, and great stability, and display high-brightness images.

### SUMMARY

The present disclosure is to provide a display device with a reduced bezel area.

More specifically, the present disclosure is to provide a display device with a reduced bezel area, which may implement high resolution.

The present disclosure is also to provide a display device that reduces a problem in which a plurality of pads is disconnected from one another.

Further, the present disclosure is to provide a display device that solves a problem in which a material, which constitutes a side line, is not properly applied onto a side surface of a substrate of the display device.

The present disclosure is not limited to the above-mentioned and other features which are not mentioned above may be clearly understood by those skilled in the art from the following descriptions.

According to an aspect of the present disclosure, a display device includes a substrate on which a plurality of light-emitting elements is disposed; a transistor on the substrate; a plurality of signal lines on the substrate; a plurality of link lines below the substrate; and a plurality of upper pads on the substrate and connected to the plurality of signal lines, in which the plurality of upper pads is disposed to overlap with at least one of the plurality of signal lines and the plurality of transistors. Therefore, it is possible to implement the high-resolution display device with zero (or minimised) bezel by reducing the bezel area of the display device.

Other detailed matters of embodiments are included in the detailed description and the drawings.

According to the present disclosure, the pad may be disposed to overlap with at least one of the plurality of signal lines and the plurality of transistors, thereby reducing the bezel area of the display device.

According to the present disclosure, a high-resolution display device can be implemented by reducing a bezel area.

According to the present disclosure, the problem of a plurality of pads disconnected by a physical impact can be resolved.

According to the present disclosure, side lines disposed on the side surface of the substrate can be uniformly disposed.

The effects according to the present disclosure are not limited to the contents exemplified above, and more various effects are included in the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic plan view (or top view) of a display device according to a first embodiment;
FIG. 2A is a schematic plan view of a display device in a state before performing a process of grinding the display device of according to the first embodiment;
FIG. 2B is a schematic cross-sectional view of the display device taken along line II-II' in FIG. 2A;
FIG. 3A is a schematic plan view of the display device after performing a process of grinding the display device according to the first embodiment;
FIG. 3B is a schematic cross-sectional view of the display device taken along line III-III' in FIG. 3A;
FIG. 4A is a schematic cross-sectional view of a display device in a state before performing a process of grinding a display device according to a second embodiment;
FIG. 4B is a schematic cross-sectional view of the display device in a state after performing a process of grinding the display device according to the second embodiment; and
FIG. 5 is a schematic cross-sectional view of a display device according to a third embodiment.

### DETAILED DESCRIPTION

Advantages and characteristics of the present disclosure and a method of achieving the advantages and characteristics will be clear by referring to embodiments described below in detail together with the accompanying drawings. However, the present disclosure is not limited to the embodiments disclosed herein but will be implemented in various forms. The embodiments are provided by way of example only so that those skilled in the art may fully understand the disclosures of the present disclosure and the scope of the present disclosure.

The shapes, sizes, ratios, angles, numbers, and the like illustrated in the accompanying drawings for describing the embodiments are merely examples, and the present disclosure is not limited thereto. Like reference numerals generally denote like elements throughout the disclosure. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The features of various aspects of the present disclosure may be partially or entirely adhered to or combined with each other and may be interlocked and operated in technically various ways, and the aspects may be carried out independently of or in association with each other.

Hereinafter, the present disclosure will be described in detail with reference to accompanying drawings.

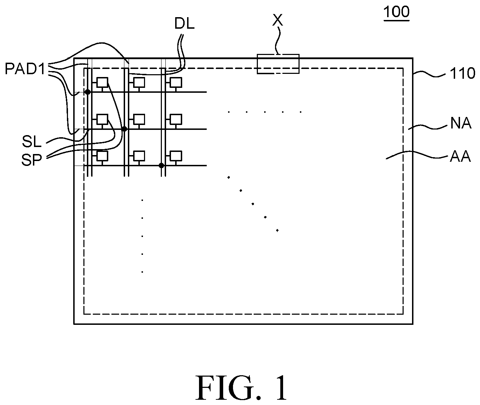

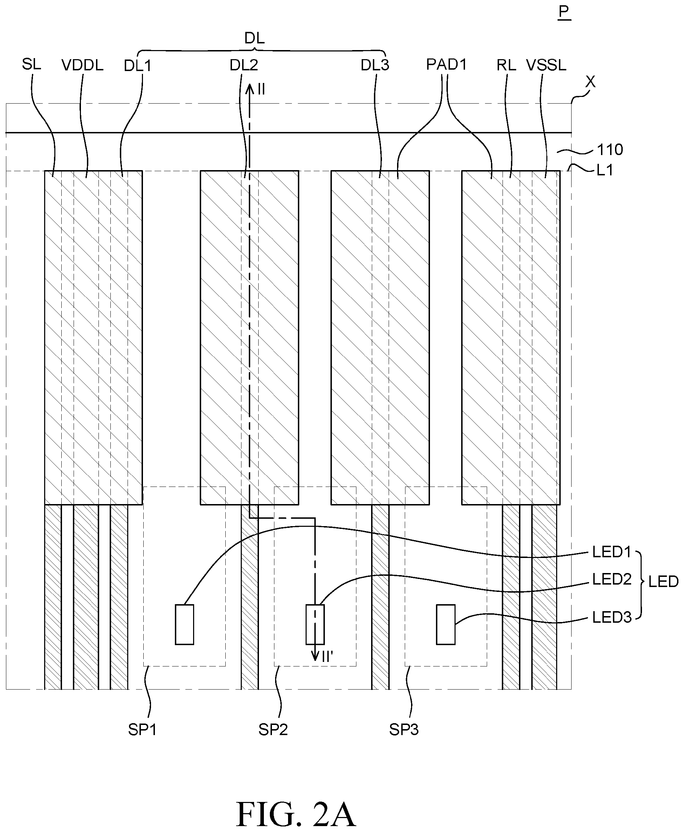

FIG. 1 is a plan view (or a top view) of a display device according to a first embodiment. For convenience of description, FIG. 1 illustrates only a substrate 110, a data line DL, a scan line SL, a plurality of subpixels SP, and an upper pad PAD1 of a display device 100. In addition, there is area X shown in FIG. 1 that will be described with reference to FIG. 2A.

With reference to FIG. 1, it may be seen that the substrate 110 may be a substrate, *e.g.,* an insulation substrate that supports constituent elements disposed on an upper portion of the display device 100. For example, the substrate 110 may be made of glass, resin, or the like. In addition, the substrate 110 may include polymer or plastic. In embodiments, the substrate 110 may be made of a plastic material having flexibility.

The substrate 110 may have a display area AA, and a non-display area NA configured to surround the display area AA.

The display area AA is an area of the display device 100 in which images are displayed. The display area AA may include the plurality of subpixels SP constituting the plurality of pixels, and a circuit configured to operate the subpixels SP.

The subpixels SP are minimum units that constitute the display area AA. A light-emitting element, a thin-film transistor for operating the light-emitting element, and the like may be disposed in each of the subpixels SP. The subpixels SP will be described in more detail with reference to FIGs. 2A to 3B.

A plurality of signal lines for transmitting various types of signals to the plurality of subpixels SP is disposed in the display area AA. For example, the plurality of signal lines may include a plurality of data lines DL for supplying data voltages to the plurality of subpixels SP, and a plurality of scan lines SL for supplying scan voltages to the plurality of subpixels SP. The plurality of signal lines will be described below in more detail with reference to FIGs. 2A to 3B.

The non-display area NA may be defined as an area in which no image is displayed, i.e., an area that surrounds the display area AA. The non-display area NA may include link lines and pad electrodes for transmitting signals to the subpixels SP in the display area AA. Alternatively, or in addition, the non-display area NA may include drive ICs such as gate drivers IC and data drivers IC.

A plurality of upper pads PAD 1 for transmitting various types of signals to the plurality of subpixels SP on the substrate 110 is disposed in the non-display area NA. The plurality of upper pads PAD1 is disposed to overlap with the plurality of signal lines to be described below. In addition, the plurality of upper pads PAD1 may be electrically connected to side lines and the plurality of signal lines in the display area AA and provide the plurality of subpixels SP with signals received from a plurality of flexible films and a printed circuit board disposed on a rear surface of the substrate 110. The plurality of upper pads PAD1 will be described in more detail with reference to FIGs. 2A to 3B.

Embodiments are not limited to the upper pads overlapping the signal lines. That is, the upper pads may not overlap the signal lines. The signal lines and upper pads may be alternately disposed (e.g. with the signal lines being disposed between the upper pads). In this arrangement, the upper pads may still be connected to the signal lines via the side lines, for example if the side lines are extended in width to cover an end of the upper pads as well as an end of the signal lines.

Meanwhile, in the present disclosure, the configuration has been described in which the display area AA and the non-display area NA are defined on a front surface of the display device 100. However, the present disclosure is not limited thereto. The non-display area NA may not be defined on the front surface of the display device 100. In case that the plurality of display devices 100 according to the first embodiment is connected to implement a tiling display having a large screen, an interval between an outermost peripheral subpixel SP of one display device 100 and an outermost peripheral subpixel SP of another display device 100 adjacent to one display device 100 may be implemented to be equal to an interval between the plurality of subpixels SP in one display device 100, such that a zero bezel in which the bezel area is not substantially present may be implemented. Therefore, only the display area AA, in which images are displayed, may be defined on the front surface of the display device 100. However, the present disclosure is not limited thereto.

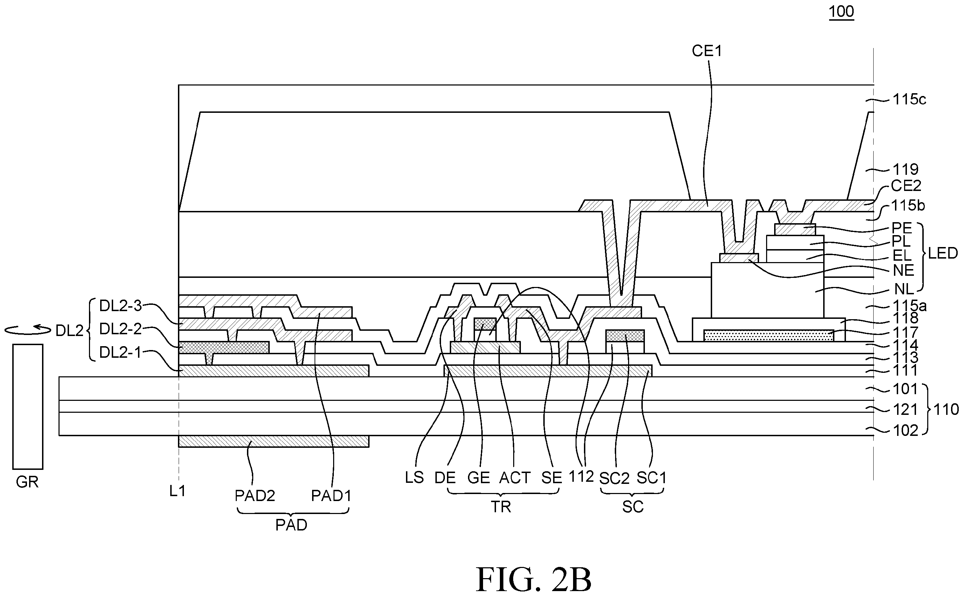

FIG. 2A is a schematic plan view of a display device in a state made before a process of grinding the display device according to the first embodiment. FIG. 2B is a schematic cross-sectional view of the display device taken along line II-II' in FIG. 2A. FIG. 2A is an enlarged plan view of area X shown in FIG. 1. FIG. 2A illustrates only the plurality of upper pads PAD1, a plurality of signal lines, a plurality of light-emitting elements LED, and a plurality of pixels P on the substrate 110.

With reference to FIG. 2A, a plurality of display modules includes the plurality of signal lines and the plurality of pixels P.

The plurality of pixels P may include a first subpixel SP1, a second subpixel SP2, and a third subpixel SP3. The first subpixel SP1, the second subpixel SP2, and the third subpixel SP3 may be subpixels that emit light with different colors. For example, the first subpixel SP1, the second subpixel SP2, and the third subpixel SP3 may be respectively a red subpixel configured to emit red light, a green subpixel configured to emit green light, and a blue subpixel configured to emit blue light. However, the present disclosure is not limited thereto. For example, the plurality of pixels P may further include a white subpixel configured to emit white light.

The plurality of subpixels SP1, SP2, and SP3 may each include a light-emitting area and a circuit area. An area, in which light emitted from the light-emitting element LED may propagate to the outside, may be defined as the light-emitting area. The light-emitting area is an area that may independently emit light with a single type of color. The light-emitting element LED may be disposed in the light-emitting area. For example, a first light-emitting element LED1 configured to emit red light may be disposed on the first subpixel SP1. A second light-emitting element LED2 configured to emit green light may be disposed on the second subpixel SP2. A third light-emitting element LED3 configured to emit blue light may be disposed on the third subpixel SP3.

The circuit area is the remaining area excluding the light-emitting area. A drive circuit for operating the plurality of light-emitting elements LED may be disposed in the circuit area. For example, the drive circuit including a transistor TR and a storage capacitor SC may be disposed in the circuit area.

The plurality of signal lines is disposed on the substrate 110. A side surface of each of the plurality of signal lines may be disposed in a plane indicated by a first line L1 in FIG.s 2A and 2B, said plane being the location where a process of grinding the substrate 110 is ended.

The plurality of signal lines may be lines for transmitting various types of signals to the drive circuit and include the scan line SL, the data line DL, a high-potential voltage line VDDL, a reference line RL, a low-potential voltage line VSSL, and the like. However, the present disclosure is not limited thereto.

Each data line DL is a line for transmitting data signals to a respective subpixel SP1, SP2, or SP3. The plurality of data lines DL may be disposed to extend in a column direction between the plurality of subpixels SP1, SP2, and SP3 and include a first data line DL1, a second data line DL2, and a third data line DL3. The first data line DL1, the second data line DL2, and the third data line DL3 may transmit data voltages to the subpixels SP1, SP2, and SP3, respectively. For example, the first data line DL1 may transmit the data voltage to the first subpixel SP1, the second data line DL2 may transmit the data voltage to the second subpixel SP2, and the third data line DL3 may transmit the data voltage to the third subpixel SP3.

The plurality of high-potential voltage lines VDDL is lines for transmitting a high-potential power voltage to the plurality of subpixels SP1, SP2, and SP3. The plurality of high-potential voltage lines VDDL may extend in the column direction.

The plurality of subpixels SP1, SP2, and SP3 may share the single high-potential voltage line VDDL. For example, the single high-potential voltage line VDDL may be disposed between the first subpixel SP1 and the third subpixel SP3 and supply a high-potential power voltage to the first subpixel SP1, the second subpixel SP2, and the third subpixel SP3.

The plurality of reference lines RL includes lines that extend in the column direction and transmit reference voltages to the plurality of subpixels SP1, SP2, and SP3. The plurality of subpixels SP1, SP2, and SP3 may share a single reference line RL. For example, the single reference line RL may be disposed between the third subpixel SP3 and the first subpixel SP1 and transmit the reference voltages to the first subpixel SP1, the second subpixel SP2, and the third subpixel SP3.

The low-potential voltage line VSSL is a line for applying a low-potential power voltage to the plurality of subpixels SP1, SP2, SP3. The low-potential voltage line VSSL may extend in the column direction. The subpixels SP1, SP2, and SP3 may share a single low-potential voltage line VSSL. For example, the single low-potential voltage line VSSL may be disposed between the first subpixel SP1 and the third subpixel SP3 and supply low-potential power voltages to the first subpixel SP1, the second subpixel SP2, and the third subpixel SP3.

Hereinafter, various constituent elements of the display device 100 will be described in more detail with reference to FIG. 2B.

With reference to FIG. 2B, the substrate 110 for supporting various constituent elements disposed on the display device 100 may be disposed on the display device 100.

The substrate 100 may include a first substrate 101 and a second substrate 102.

The first substrate 101 may be a substrate, e.g., an insulation substrate, that supports the constituent elements disposed on an upper portion of the display device 100. For example, the first substrate 101 may be made of glass, resin, or the like. Alternatively, or in addition, the first substrate 101 may include polymer or plastic.

The second substrate 102 is disposed below the first substrate 101. The second substrate 102 may be a substrate, e.g., an insulation substrate that supports the constituent elements disposed on a lower portion of the display device 100. For example, the second substrate 102 may be made of glass, resin, or the like. Alternatively, or in addition, the second substrate 102 may include polymer or plastic. The second substrate 102 may be made of the same material as the first substrate 101.

A first bonding layer 121 is disposed between the first substrate 101 and the second substrate 102. The first bonding layer 121 may be made of a material that may be cured in various curing ways to bond the first substrate 101 and the second substrate 102. The first bonding layer 121 may be disposed on a partial area or the entire area between the first substrate 101 and the second substrate 102.

With reference to FIG. 2B, a light-blocking layer LS may be disposed on the first substrate 101.

The light-blocking layer LS may be disposed to overlap with an first active layer ACT of the transistor TR and block light entering the first active layer ACT. If the light is emitted to the first active layer ACT, a leakage current occurs, which may degrade the reliability of the transistor TR that is a driving transistor. In this case, when the light-blocking layer LS made of an opaque electrically conductive material such as copper (Cu), aluminum (Al), molybdenum (Mo), nickel (Ni), titanium (Ti), chromium (Cr), and an alloy thereof is disposed to overlap with the first active layer ACT, the light-blocking layer LS may inhibit the light from entering the first active layer ACT from the lower portion of the substrate 110, thereby improving the reliability of the transistor TR.

A buffer layer 111 is disposed on the first substrate 101 and the light-blocking layer LS. The buffer layer 111 may reduce penetration of moisture or impurities through the first substrate 101. For example, the buffer layer 111 may be configured as a single layer or multilayer made of silicon oxide (SiOx) or silicon nitride (SiNx). However, the present disclosure is not limited thereto. In addition, the buffer layer 111 may be excluded in accordance with the type of first substrate 101 or the type of transistor TR. However, the present disclosure is not limited thereto.

The transistor TR is disposed on the buffer layer 111 of each of the plurality of subpixels SP1, SP2, and SP3.

The transistor TR includes the first active layer ACT, a gate electrode GE, a source electrode SE, and a drain electrode DE.

The first active layer ACT is disposed on the buffer layer 111. The first active layer ACT may be made of a semiconductor material such as an oxide semiconductor, amorphous silicon, or polysilicon. However, the present disclosure is not limited thereto. For example, in case that the first active layer ACT is made of oxide semiconductor, the first active layer ACT may include the channel region, the source region, and the drain region, and the source region and the drain region may be regions having conductivity. However, the present disclosure is not limited thereto.

A gate insulation layer 112 is disposed on the first active layer ACT. The gate insulation layer 112 may be a layer for insulating the gate electrode GE and the first active layer ACT and made of an insulating material. For example, the gate insulation layer 112 may be configured as a single layer or multilayer made of silicon oxide (SiOx) or silicon nitride (SiNx). However, the present disclosure is not limited thereto.

The gate insulation layer 112 may be formed in the same pattern as the gate electrode GE. However, the present disclosure is not limited thereto. The gate insulation layer 112 may be formed on a front (or upper) surface of the first substrate 101.

The gate electrode GE is disposed on the gate insulation layer 112. The gate electrode GE may be disposed to overlap with the gate insulation layer 112. The gate electrode GE may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

An interlayer insulation layer 113 is disposed on the gate electrode GE and the buffer layer 111. The interlayer insulation layer 113 may be a layer for insulating the gate electrode GE, the source electrode SE, and the drain electrode DE. The interlayer insulation layer 113 may be made of an inorganic material, like the gate insulation layer 112. For example, the interlayer insulation layer 113 may be configured as a single layer or multilayer made of silicon oxide (SiOx) or silicon nitride (SiNx). However, the present disclosure is not limited thereto.

The source electrode SE and the drain electrode DE disposed on the interlayer insulation layer 113 and spaced apart from each other. The source electrode SE and the drain electrode DE may be electrically connected to the first active layer ACT through a via hole formed in the interlayer insulation layer 113. The source electrode SE and the drain electrode DE may be disposed on the same layer and made of the same electrically conductive material as the gate electrode GE. However, the present disclosure is not limited thereto. For example, the source electrode SE and the drain electrode DE may each be made of copper (Cu), aluminum (Al), molybdenum (Mo), nickel (Ni), titanium (Ti), chromium (Cr), or an alloy thereof. However, the present disclosure is not limited thereto.

The drain electrode DE is electrically connected to the low-potential voltage line VSSL. For example, the drain electrode DE of each of the second and third subpixels SP2 and SP3 may be electrically connected to the low-potential voltage line VSSL disposed at the left side of the first subpixel SP1.

The source electrode SE may be electrically connected to the light-blocking layer LS through via holes formed in the interlayer insulation layer 113 and the buffer layer 111. If the light-blocking layer LS floats, a threshold voltage of the transistor TR is changed, which may affect the operation of the display device 100. Therefore, the light-blocking layer LS may be electrically connected to the source electrode SE, such that the voltage may be applied to the light-blocking layer LS, and the operation of the transistor TR may not be affected. However, the present disclosure is not limited thereto. Both the first active layer ACT and the source electrode SE may be in direct contact with the light-blocking layer LS. The plurality of signal lines may be disposed on the interlayer insulation layer 113. For example, the plurality of signal lines may include the plurality of scan lines SL, the plurality of high-potential voltage lines VDDL, the plurality of data lines DL, and the plurality of reference lines RL. However, the present disclosure is not limited thereto. The plurality of signal lines may be disposed on the same layer on the first substrate 101 and made of the same electrically conductive material. The plurality of scan lines SL, the plurality of high-potential voltage lines VDDL, the plurality of data lines DL, and the plurality of reference lines RL may each be made of an electrically conductive material such as copper (Cu), aluminum (Al), molybdenum (Mo), nickel (Ni), titanium (Ti), chromium (Cr), or an alloy thereof. However, the present disclosure is not limited thereto. The plurality of signal lines may be disposed on different layers on the first substrate 101 and made of different electrically conductive materials. In addition, the plurality of signal lines may be made of the same material as the drain electrode DE and the source electrode SE. Meanwhile, the plurality of signal lines may be disposed on different layers on the first substrate 101 and made of different electrically conductive materials. In this case, the plurality of signal lines may each be disposed on the same layer and made of the same material as any one of the constituent elements that constitute the transistor TR.

The storage capacitor SC is disposed in the circuit area of each of the plurality of subpixels SP1, SP2, and SP3. The storage capacitor SC may store a voltage between the gate electrode GE and the source electrode SE of the transistor TR so that the light-emitting element LED may continuously maintain the same state during a single frame. The storage capacitor SC includes a first capacitor electrode SC1 and a second capacitor electrode SC2.

The first capacitor electrode SC1 is disposed between the first substrate 101 and the buffer layer 111 in each of the plurality of subpixels SP. The first capacitor electrode SC1 may be disposed to be closest to the first substrate 101 among the conductive constituent elements disposed on the first substrate 101. The first capacitor electrode SC1 may be integrated with the light-blocking layer LS and may be electrically connected to the source electrode SE through the light-blocking layer LS.

The buffer layer 111 and the gate insulation layer 112 are disposed on the first capacitor electrode SC1, and the second capacitor electrode SC2 is disposed on the buffer layer 111 and the gate insulation layer 112. The second capacitor electrode SC2 may be disposed to overlap with the first capacitor electrode SC1. The second capacitor electrode SC2 may be made of the same material as the gate electrode GE. For example, the gate electrode GE and the second capacitor electrode SC2 may be formed by forming a semiconductor material on the gate insulation layer 112 and patterning a part of the semiconductor material.

A passivation layer 114 is disposed on the transistor TR and the storage capacitor SC. The passivation layer 114 is an insulation layer for protecting the components disposed on a lower portion of the passivation layer 114. For example, the passivation layer 114 may be configured as a single layer or multilayer made of silicon oxide (SiOx) or silicon nitride (SiNx). However, the present disclosure is not limited thereto. In addition, the passivation layer 114 may be excluded in accordance with some embodiments.

A plurality of reflective layers 117 is disposed on the passivation layer 114. The reflective layer 117 may be disposed to overlap with the light-emitting area including the light-emitting element LED. The reflective layer 117 reflects the light, which enters from the light-emitting element LED, toward an upper portion of the light-emitting element LED, thereby improving luminous efficiency of the display device 100. However, in case that the display device 100 is a back emission type display device, the reflective layer 117 may be excluded or disposed on the upper portion of the light-emitting element LED.

A second bonding layer 118, which covers the reflective layer 117, is disposed on the reflective layer 117. The second bonding layer 118 is a bonding layer for bonding the light-emitting element LED onto the reflective layer 117. The second bonding layer 118 may insulate the reflective layer 117 and the light-emitting element LED each made of a metallic material. The second bonding layer 118 may be made of a thermosetting or photocurable material. However, the present disclosure is not limited thereto. FIG. 2B illustrates that the second bonding layer 118 is disposed to cover only the reflective layer 117. However, an arrangement position of the second bonding layer 118 is not limited thereto.

The plurality of light-emitting elements LED is disposed on the second bonding layer 118. The plurality of light-emitting elements LED is disposed to overlap with the plurality of reflective layers 117. Each of the light-emitting elements LED may be a microLED including an inorganic active layer. The plurality of light-emitting elements LED each includes an n-type layer, an active layer, a p-type layer, an n-electrode, and a p-electrode. Hereinafter, the configuration is described in which a light-emitting element LED having a lateral structure is used as the light-emitting element LED. The n-electrode or the p-electrode may be disposed on top of the light-emitting element LED. The n-electrode and the p-electrode may be disposed to be spaced apart horizontally. However, the structure of the light-emitting element LED is not limited thereto.

Specifically, an n-type layer NL of the light-emitting element LED is disposed on the second bonding layer 118. The n-type layer NL may be formed by injecting n-type impurities into gallium nitride having excellent crystallinity. A second active layer EL is disposed on the n-type layer NL. The second active layer EL may be a light-emitting layer provided in the light-emitting element LED and configured to emit light. The second active layer EL may be made of a nitride semiconductor, e.g., indium gallium nitride. A p-type layer PL is disposed on the second active layer EL. The p-type layer PL may be formed by injecting p-type impurities into gallium nitride. However, the constituent materials of the n-type layer NL, the second active layer EL, and the p-type layer PL are not limited thereto.

A p-electrode PE is disposed on the p-type layer PL of the light-emitting element LED. In addition, an n-electrode NE is disposed on the n-type layer NL of the light-emitting element LED. The n-electrode NE is disposed to be spaced apart from the p-electrode PE. Specifically, the light-emitting element LED may be manufactured by sequentially stacking the n-type layer NL, the active layer EL, and the p-type layer PL, etching predetermined portions of the active layer EL and the p-type layer PL, and forming the n-electrode NE and the p-electrode PE. In this case, the predetermined portions are spaces for separating the n-electrode NE and the p-electrode PE. The predetermined portions may be etched so that a part of the n-type layer NL is exposed. In other words, a surface of the light-emitting element LED, on which the n-electrode NE and the p-electrode PE are to be disposed, may be a surface having different height levels instead of a planarized surface. Therefore, the p-electrode PE is disposed on the p-type layer PL, and the n-electrode NE is disposed on the n-type layer NL. The p-electrode PE and the n-electrode NE are disposed to be spaced apart from each other at different height levels. Therefore, the n-electrode NE may be disposed to be closer to the second bonding layer 118 than the p-electrode PE. Further, the n-electrode NE and the p-electrode PE may be made of an electrically conductive material, e.g., transparent conducting oxide. In addition, the n-electrode NE and the p-electrode PE may be made of the same material. However, the present disclosure is not limited thereto.

A first planarization layer 115a is disposed on the transistor TR. The first planarization layer 115a may be disposed in an area excluding an area in which the light-emitting element LED is disposed. The first planarization layer 115a planarizes an upper surface of the transistor TR.

The first planarization layer 115a may be configured as a single layer or multilayer made of an organic material, for example, polyimide or photo acrylic. However, the present disclosure is not limited thereto.

A second planarization layer 115b is disposed on the first planarization layer 115a and the light-emitting element LED. The second planarization layer 115b is a layer for planarizing an upper surface of the transistor TR and an upper surface of the light-emitting element LED. FIG. 2B illustrates that the first planarization layer 115a and the second planarization layer 115b are disposed. However, the present disclosure is not limited thereto. A single planarization layer may be formed. In case that a single planarization layer is disposed, it is possible to suppress an excessive increase in amount of time required for the process. In addition, two or more planarization layers may be provided. The second planarization layer 115b may be made of the same material as the first planarization layer 115a. However, the present disclosure is not limited thereto.

A first electrode CE1 is an electrode that electrically connects the transistor TR and the light-emitting element LED. The first electrode CE1 is connected to the n-electrode NE of the light-emitting element LED through a via hole formed in the second planarization layer 115b. In addition, the first electrode CE1 is connected to the source electrode SE of the transistor TR through via holes formed in the planarization layers 115a and 115b and the passivation layer 114. However, the present disclosure is not limited thereto. The first electrode CE1 may be connected to the drain electrode DE of the transistor TR in accordance with the type of transistor TR.

A second electrode CE2 is an electrode that electrically connects the light-emitting element LED and the high-potential voltage line VDDL. Specifically, the second electrode CE2 is connected to the high-potential voltage line VDDL through via holes formed in the planarization layers 115a and 115b and the passivation layer 114. The second electrode CE2 is connected to the p-electrode PE of the light-emitting element LED through a via hole formed in the second planarization layer 115b. Therefore, the high-potential voltage line VDDL and the p-electrode PE of the light-emitting element LED are electrically connected.

The first electrode CE1 and the second electrode CE2 are spaced apart from each other. Specifically, the first electrode CE1 may be surrounded by the first planarization layer 115a, the second planarization layer 115b and the third planarization layer 115c. The second electrode CE2 may be surrounded by the first planarization layer 115a, the second planarization layer 115b and the third planarization layer 115c. The second planarization layer 115b and the third planarization layer 115c may be in contact with each other in an area between the first electrode CE1 and the second electrode CE2. The third planarization layer 115c may be disposed between the first electrode CE1 and the second electrode CE2. Accordingly, the first electrode CE1 and the second electrode CE2 are electrically insulated from each other.

A bank 119 is disposed on the second planarization layer 115b, the first electrode CE1, and the second electrode CE2. The bank 119 is an insulation layer that defines the light-emitting area. The bank 119 may be made of an organic insulating material. The bank 119 may be made of the same material as the planarization layers 115a and 115b. In addition, the bank 119 may be configured to include a light absorbing material, such as a black material, to suppress a color mixture caused when light emitted from the light-emitting element LED is transmitted to the adjacent subpixels SP1, SP2, and SP3. The bank 119 may have slopes. Specifically, side surfaces of the bank 119 may be formed as an inclined surfaces with a specific slope. Further, the bank 119 may overlap with the upper pads PAD1 or the lower pads PAD2. The bank 119 may cover an area where the upper pads PAD1 and the lower pads PAD2 are disposed.

A third planarization layer 115c is disposed on the bank 119. The third planarization layer 115c may planarize an upper portion of the first substrate 101 and protect the components disposed below the third planarization layer 115c. The third planarization layer 115c may be configured as a single layer or multilayer made of an organic material, for example, polyimide or photo acrylic. However, the present disclosure is not limited thereto.

With reference to FIG. 2B, the plurality of signal lines is disposed on the first substrate 101 and disposed at an end of the first substrate 101. The plurality of signal lines may include the plurality of scan lines SL, the plurality of high-potential voltage lines VDDL, the plurality of low-potential voltage line VSSL, the plurality of data lines DL, and the plurality of reference lines RL. For convenience of description, FIG. 2B illustrates the second data line DL2 among the plurality of signal lines.

The second data line DL2 may include a first layer DL2-1, a second layer DL2-2, and a third layer DL2-3. The second data line DL2 may have a jumping line structure through the first layer DL2-1, the second layer DL2-2, and the third layer DL2-3. In other words, at least one of the first layer DL2-1, the second layer DL2-2, and the third layer DL2-3 may function as a jumping line. The first layer DL2-1, the second layer DL2-2, the third layer DL2-3 and the upper pad PAD1 may be electrically connected in parallel to each other through holes in insulating layers disposed therebetween. Accordingly, resistance of the second data line DL2 may be reduced.

More generally, each of the signal lines comprises at least two overlapping signal line layers connected in parallel to each other. There may be an insulating layer disposed between each of an adjacent pair of the at least two overlapping signal line layers. The insulating layer may comprise through holes which receive corresponding connecting portions connecting the adjacent pair. The signal line may be electrically connected to the upper pad, optionally wherein the signal line is electrically connected in parallel to the upper pad. An insulating layer may be disposed between the upper pad and the signal line. The insulating layer comprises a through hole which receives a connecting portion connecting the signal line and the upper pad.

The first layer DL2-1 may be disposed on the same layer as the light-blocking layer LS and made of the same electrically conductive material as the light-blocking layer LS. However, the present disclosure is not limited thereto.

The buffer layer 111 and the second layer DL2-2 may be disposed on the first layer DL2-1.

The second layer DL2-2 may be disposed on the same layer as the gate electrode GE and made of the same electrically conductive material as the gate electrode GE. However, the present disclosure is not limited thereto.

An outer end of the second layer DL2-2 may be disposed on the same plane (e.g. the plane indicated by line L1 in FIG.s 2A and 2B) as an outer end of the first layer DL2-1. In addition, the second layer DL2-2 may be disposed to overlap with the first layer DL2-1 disposed on a lower portion of (i.e. below) the second layer DL2-2. FIG. 2B illustrates that the second layer DL2-2 is disposed to overlap with a part of the first layer DL2-1. However, the present disclosure is not limited thereto. For example, the second layer DL2-2 may be disposed to overlap the first layer DL2-1 entirely. The second layer DL2-2 may be disposed to overlap with a front (or upper) surface of the first layer DL2-1.

The second layer DL2-2 may be electrically connected to the first layer DL2-1 through a contact hole formed in the buffer layer 111. Therefore, the second layer DL2-2 may implement a structure connected in parallel to the first layer DL2-1, thereby reducing resistance of the second data line DL2.

The interlayer insulation layer 113 and the third layer DL2-3 are disposed on the second layer DL2-2. The third layer DL2-3 may be disposed to overlap with the plurality of upper pads PAD 1 disposed on an upper portion of (i.e. above) the third layer DL2-3.

The third layer DL2-3 may be disposed on the same layer as the source electrode SE and the drain electrode DE and made of the same electrically conductive material as the source electrode SE and the drain electrode DE. However, the present disclosure is not limited thereto.

An outer end of the third layer DL2-3 may be disposed on the same plane (e.g. the plane indicated by line L1 in FIG.s 2A and 2B) as an end of the first layer DL2-1 and an end of the second layer DL2-2. In addition, the third layer DL2-3 may be disposed to overlap with the second layer DL2-2 and the first layer DL2-1. FIG. 2B illustrates that an inner end (i.e. the end farthest from the line L1) of the third layer DL2-3 is disposed between the inner end of the second layer DL2-2 and the inner end of the first layer DL2-1. However, a position of the inner end of the third layer DL2-3 is not limited thereto.

The third layer DL2-3 may be electrically connected to the second layer DL2-2 through a contact hole formed in the interlayer insulation layer 113. Therefore, the second layer DL2-2 and the third layer DL2-3 may be implemented as structures connected to each other in parallel, thereby reducing resistance of the second data line DL2.

Meanwhile, an electrostatic discharge circuit may be disposed on the substrate 110 to overlap with the plurality of upper pads PAD1. The electrostatic discharge circuit is disposed in an area between the plurality of upper pads PAD1 and the display area AA. The electrostatic discharge circuit may be electrically connected to the second data line DL2. When static electricity is introduced through the second data line DL2, the electrostatic discharge circuit may be turned on and discharge the static electricity to a ground line, thereby blocking (reducing or eliminating) the static electricity. In other words, the electrostatic discharge unit may be selectively electrically connectable to the ground line and electrically connected to a signal line (e.g. the second data line DL2) or vice versa. Therefore, the electrostatic discharge circuit may suppress damage to the display device 100 by blocking or discharging a flow of overcurrent caused by static electricity. The electrostatic discharge circuit may be electrically connected to the signal line via the side line 140.

The electrostatic discharge circuit may overlap the upper pads PAD1 and/or the lower pads PAD2, thereby providing a more compact arrangement at the edge of the display device so that a bezel may be reduced or eliminated.

The bank 119 may be disposed on the electrostatic discharge circuit to partially or fully overlap the electrostatic discharge circuit. The bank may extend to an edge of the display device. The bank 119 may include a light absorbing (e.g. a black material). Therefore, the bank may prevent external light from impinging on and reflecting off the electrostatic discharge circuit. Thereby, the edge of the display may have a same appearance as an area between subpixels.

The passivation layer 114 and an upper pad of the plurality of upper pads PAD1 are disposed on the third layer DL2-3.

A side surface of each of the plurality of upper pads PAD1 may be disposed on the same plane (e.g. the plane indicated by line L1 in FIG.s 2A and 2B) as a side surface of each of the plurality of signal lines including the second data line DL2.

Meanwhile, FIG. 2B illustrates that an upper pad PAD1 overlaps with only the second data line DL2 that is the signal line. However, the upper pads PAD1 may each be disposed to overlap with at least one of the signal lines and/or at least one of the transistors TR.

The upper pads PAD1 may overlap with either the signal line DL2 or the TFT or both. This has the technical effect of reducing the size of the area between the LED and the edge of the display panel, thereby reducing the bezel size or eliminating the bezel altogether (for example such that the distance between the LED and the edge of the display panel is half the pitch between adjacent LEDs).

At the edge of the display device bank 119 may partially or fully overlap the signal lines (e.g. the second data line DL2) and/or the upper pads PAD1 and/or lower pads PAD2. The bank 119 may include a light blocking (e.g. a black material) and may extend to an edge of the substrate 110. Therefore, the bank may prevent external light from impinging on and reflecting off the upper pads PAD1 and/or the signal lines (e.g. second data line DL2). Thereby, the edge of the display device may have a same appearance as an area between subpixels.

The plurality of upper pads PAD1 (disposed on a front surface or topside of the substrate 110) may be electrically connected to side lines 140 to be described below and the plurality of signal lines in the display area AA and provide the plurality of subpixels SP with signals received from the plurality of flexible films and the printed circuit board disposed on the rear surface (i.e. underside) of the substrate 110.

A plurality of lower pads PAD2 is disposed on a lower surface (i.e., rear surface or underside) of the second substrate 102.

The plurality of lower pads PAD2 may transmit signals, which are received from a drive part disposed on a rear surface of the second substrate 102, to the plurality of side lines 140 and thereby to the plurality of upper pads PAD 1 and the plurality of signal lines. The plurality of lower pads PAD2 may be disposed at an end of the second substrate 102 in the non-display area NA and electrically connected to the side lines 140 that cover (or are disposed on) a side surface of the second substrate 102 (as well as the side surfaces of the other layers at the edge of the display device).

The plurality of lower pads PAD2 may be disposed at a position at which the plurality of lower pads PAD2 overlap with the plurality of upper pads PAD1. The plurality of upper pads PAD1 and the plurality of lower pads PAD2 overlap with and are electrically connected with one another through the side lines 140. The plurality of lower pads PAD2 and signal lines may also overlap with and electrically connect with one another through the side lines 140. Meanwhile, although not illustrated in FIG. 2B, a plurality of link lines, a plurality of flexible films, a printed circuit board, and the like may be disposed below the second substrate 102.

The plurality of link lines may provide the plurality of signal lines of the display device 100 with various signals and voltages received from the drive part. For example, the plurality of link lines may include a plurality of gate link lines, a plurality of data link lines, a plurality of high-potential voltage link lines, a plurality of low-potential voltage link lines, and a reference voltage link line depending on their connection to the corresponding signal lines. However, the present disclosure is not limited thereto. Here, the drive part may include the plurality of flexible films and the printed circuit board. However, the present disclosure is not limited thereto. The link lines may electrically connect the drive part to the side lines directly or via other components such as the lower pads or upper pads.

The plurality of flexible films supplies signals to the plurality of subpixels SP. The flexible films are configured such that various types of components, such as gate driver ICs and data driver Ics, are disposed on base films having flexibility. The printed circuit board is a component that is electrically connected to the plurality of flexible films and supplies a signal to the drive IC. Various types of components for supplying various signals, such as driving signals and data signals, to the drive IC may be disposed on the printed circuit board. The plurality of lower pads PAD2 may be electrically connected to the plurality of flexible films or the printed circuit board through the plurality of link lines.

For example, the plurality of lower pads PAD2 may be electrically connected to the plurality of flexible films through the plurality of link lines. The plurality of flexible films may supply various types of signals to the plurality of side lines 140, the plurality of upper pads PAD1, the plurality of signal lines, and the plurality of subpixels SP through the plurality of lower pads PAD2 and the plurality of link lines. Therefore, the signals received from the drive part may be transmitted to the plurality of subpixels SP and the signal lines on the front surface of the first substrate 101 through the plurality of lower pads PAD2 of the second substrate 102, the side lines 140, and the plurality of upper pads PAD1 of the first substrate 101. In more general terms, the signals from the drive part on the underside (or rear surface or lower surface) of the substrate 110 may be transmitted to the plurality of subpixels SP on the topside (or front surface or upper surface) via the side lines 140. The side lines 140 being connected: to the drive part via the lower pads PAD2; and to the subpixels SP via the signal lines and upper pads PAD 1. The side lines 140 may connect directly with the signal lines and/or may connect with the signal lines via the upper pads PAD1.

With reference to FIG. 2B, the first substrate 101 and the second substrate 102 may be ground (e.g. using mechanical grinding means) to the plane indicated by the first line L1 after the first substrate 101 and the second substrate 102 are bonded by means of the first bonding layer 121.

A grinder GR disposed outside the first substrate 101 and the second substrate 102 may grind the side surfaces of the first and second substrates 101 and 102 while rotating about a rotation axis. The grinder GR may grind the side surfaces of the first and second substrates 101 and 102 while moving to the first line L1 that overlaps with the plurality of signal lines and the side surfaces of the plurality of pads PAD including the upper pad PAD 1 and the lower pad PAD2. Therefore, ground surfaces may be formed on the side surfaces of the first and second substrate 101 and 102 by the grinder GR. However, the present disclosure is not limited thereto and the portion of the substrate 110 protruding from the plane indicated by line L1 may be removed in other ways such as cutting, sanding or filing.

For convenience of description, the drawing illustrates that the plurality of pads PAD remaining on the substrate 110 after the grinding process has a large area. However, the area of the plurality of pads PAD remaining on the substrate 110 may be very small to eliminate heterogeneity between the adjacent display devices 100 at the time of substantially reducing the bezel area and implementing a tiling display. In other words, the whole end of the display may be ground back (or otherwise manufactured) so that the area containing the plurality of pads PAD is minimized. This can allow a distance between the nearest edge of nearest subpixel SP and the line L1 to be reduced to, for example, half the distance between edges of adjacent subpixels so that in a tiled display containing one or more adjacent displays illustrated in FIG.s 2A & 2B (or FIG.s 3A & 3B; or 4A & 4B; or 5), there is no discontinuity of spacing of subpixels across the tiled array at the join between adjacent displays. Therefore, an appearance and performance of the tiled display is improved.

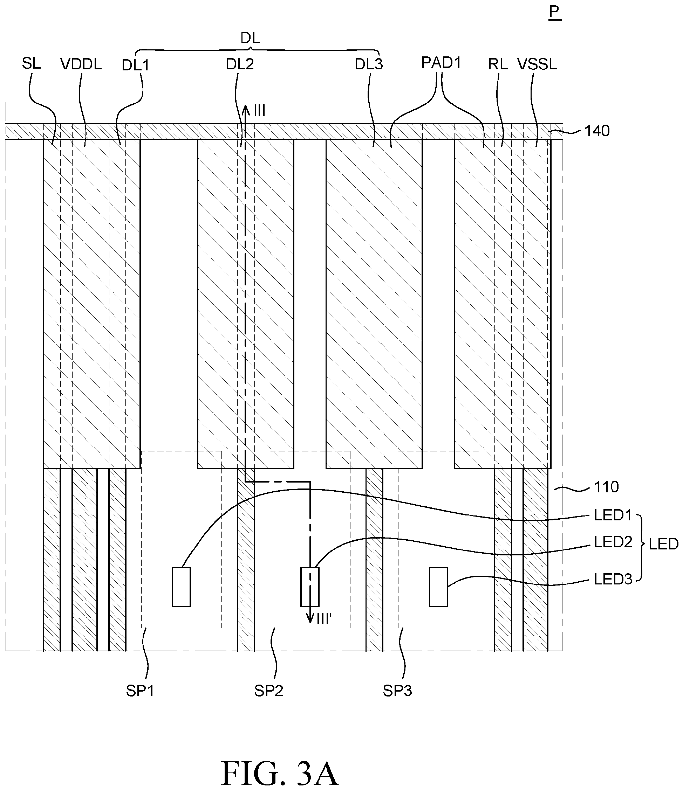

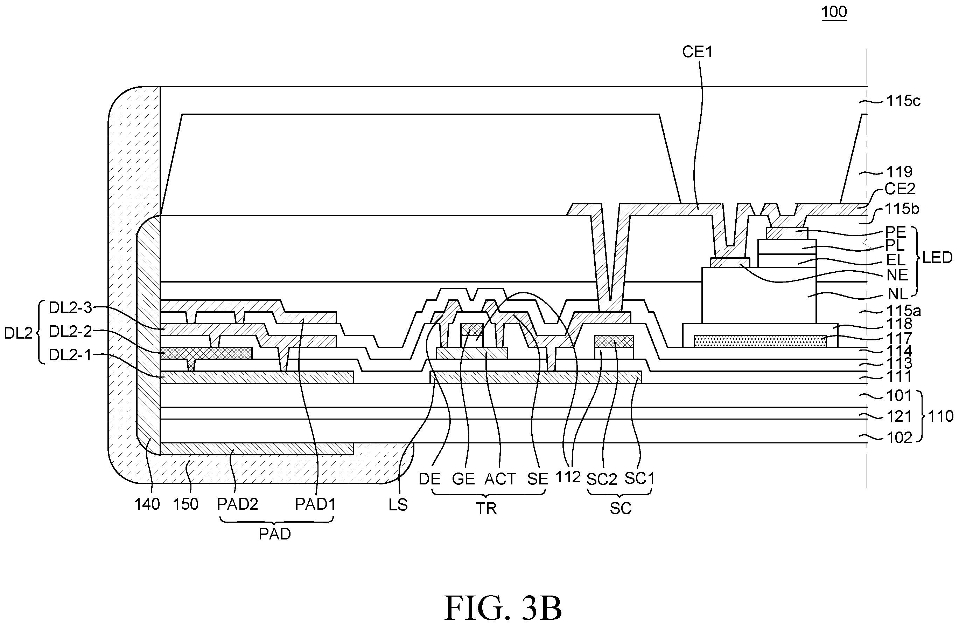

The ground surfaces of the first and second substrates 101 and 102, which are formed by the grinder GR, may have a straight shape in accordance with a shape of the grinder GR. In other words, the surfaces may be ground uniformly so that the end result is a planar ground surface. Hereinafter, the side surfaces of the first and second substrates 101 and 102 will be described below with reference to FIGs. 3A and 3B.

FIG. 3A is a schematic plan view of a subpixel of a display device according to the first embodiment. FIG. 3B is a schematic cross-sectional view of the display device taken along line III-III' in FIG. 3A. FIGs. 3A and 3B illustrates states made after the grinding process is completed. FIG. 3A illustrates the plurality of upper pads PAD1, the plurality of signal lines, the plurality of light-emitting elements LED, the plurality of side lines 140, and the plurality of pixels P on the substrate 110. Because the display device 100, which is in a state in which the grinding process is completed, is substantially identical to the display device (of e.g. FIG.s 2A & 2B) which is in a state made before the grinding process is performed, except that the plurality of side lines 140 and a side insulation layer 150 are added and the removed part of the substrate 110 is excluded, a repeated description of components, features and arrangements described with reference to FIG.s 1, 2A and 2B will be omitted.

With reference to FIGs. 3A and 3B, the side surfaces of the first and second substrates 101 and 102 of the display device 100 are disposed in a straight shape (i.e. are planar). The side surfaces of the first and second substrates 101 and 102 are disposed on the same plane as the side surfaces of the constituent elements of the display device 100 that are disposed on the upper and lower portions of the substrate 110. For example, the side surface of the first substrate 101 may be disposed on the same plane as the side surfaces of the plurality of signal lines and the plurality of upper pads PAD1 and disposed on the same plane as the side surfaces of the plurality of insulation layers disposed on the first substrate 101. The side surface of the second substrate 102 may also be disposed on the same plane as the side surfaces of the plurality of lower pads PAD2 disposed below the second substrate 102.

Following the removal (e.g. grinding) process, the plurality of side lines 140 is disposed on the side surfaces of the first and second substrates 101 and 102. The plurality of side lines 140 may electrically connect the plurality of upper pads PAD1, which is formed on the upper surface of the first substrate 101, and the plurality of lower pads PAD2 formed on the lower surface of the second substrate 102 and thereby connect the plurality of signal lines, which is formed on the upper surface of the first substrate 101, and the plurality of link lines formed on the rear surface (i.e. on the back, under, below, or on the underneath) of the second substrate 102. However, the present disclosure is not limited to include lower pads and the link lines may be connected directly to the side lines without the lower pads.

The plurality of side lines 140 may be disposed to surround the side surfaces of the display device 100. The side lines may be spaced apart from one another. The plurality of side lines 140 may respectively be in contact with the side surfaces of the plurality of upper pads PAD 1 disposed at the end of the first substrate 101, the side surfaces of the plurality of signal lines, the side surface of the first substrate 101, the side surface of the second substrate 102, and the side surfaces of the plurality of lower pads PAD2 disposed at the end of the second substrate 102. In this case, when the side surface of the substrate 110 is disposed in a plane perpendicular to the plane of the upper surface of the substrate 110, the plurality of side lines 140 may also be disposed in the direction perpendicular to the upper surface of the substrate 110.

The plurality of side lines 140 may be formed by a pad printing method using conductive ink, e.g., conductive ink including silver (Ag), copper (Cu), molybdenum (Mo), chromium (Cr), and the like.

The side insulation layer 150 is disposed to cover the plurality of side lines 140. The side insulation layer 150 may be formed to cover the side line 140 on the upper surface of the first substrate 101, the side surface of the first substrate 101, the side surface of the second substrate 102, and the rear surface of the second substrate 102. In other words, the side insulation layer 150 may cover the upper, lower and side surfaces of the side lines 140. The side insulation layer 150 may protect the plurality of side lines 140.

Meanwhile, in case that the plurality of side lines 140 is made of a metallic material, there may occur a problem in which external light is reflected by the plurality of side lines 140, or light emitted from the light-emitting element LED is reflected by the plurality of side lines 140, and a user visually recognizes the light. Therefore, the side insulation layer 150 may be configured to include a black material, thereby suppressing the reflection of external light. For example, the side insulation layer 150 may be formed by a pad printing method using an insulating material including a black material, e.g., black ink.

Meanwhile, although not illustrated in FIGs. 3A and 3B, a seal member and an optical film, which cover the side insulation layer 150, may be additionally disposed. The seal member may be disposed to surround the side surface of the display device 100 and protect the display device 100 from external impact or moisture and oxygen. For example, the seal member may be made of a material such as polyimide (PI), polyurethane, epoxy, and acrylic. However, the present disclosure is not limited thereto.

The optical film may be disposed on the seal member, the side insulation layer 150, and a protective layer. The optical film may be a functional film that implements images with higher image quality while protecting the display device 100. For example, the optical film may include an anti-glare film, an anti-reflecting film, a low-reflecting film, an OLED transmittance controllable film, or a polarizing plate. However, the present disclosure is not limited thereto.

The plurality of pads is disposed on the upper and lower sides of the substrate in the non-display area of the display device to transmit various types of signals to the plurality of subpixels. The plurality of pads may be connected between the side lines and the plurality of signal lines in the display area and provide the plurality of subpixels with signals received from the printed circuit board and the plurality of flexible films disposed below the substrate. In this case, the plurality of pads is disposed on an outer peripheral portion of the display device, i.e., the bezel area. In addition, the plurality of pads is disposed outside the plurality of signal lines and the plurality of transistors, which requires a separate area for disposing the plurality of pads and causes constraint to a decrease in bezel of the display device.

Meanwhile, an interval between an outermost peripheral light-emitting element LED of one panel and an outermost peripheral light-emitting element LED of another panel adjacent to one panel (and having the same edge structure and side lines as described in any of the embodiments described herein) is implemented to be equal to an interval between the light-emitting elements LED in one panel, such that a tiling display, which is implemented by disposing the plurality of panels in a tile shape, is implemented. Therefore, in case that the bezel area of the display device is larger than the interval between the light-emitting elements in one display panel because of a limitation in reducing sizes of the plurality of pads, a boundary between the display modules may be visually recognized by the user, which causes interruption of displayed images, and particularly causes constraint to the implementation of a large-scale panel by means of tiling.

Therefore, in the display device 100 according to the first embodiment, the plurality of pads PAD is disposed to overlap with at least one of the plurality of signal lines and the plurality of transistors TR, such that a separate area for disposing the pad PAD may be eliminated from the design, and the bezel area of the display device 100 may be reduced.

In addition, in the display device 100 according to the first embodiment, the side lines 140 are formed on the side surfaces of the first upper pad PAD1 and the plurality of lower pads PAD2, such that the side surface of the substrate 110 may be ground to be formed as a straight portion (i.e. a planar surface). That is, the plurality of side lines 140 may be formed without obliquely grinding the side surface of the substrate 110 to more smoothly connect the plurality of signal lines (e.g., gate lines GL and/or the data lines DL) disposed on the upper surface of the first substrate 101 with the plurality of link lines on the rear surface of the second substrate 102, thereby simplifying a manufacturing process. Where the term "side surface" is used to describe a surface of a features, this may be understood to mean the surface of the terminal end of the feature, for example at the edge of the display device.

In addition, in the display device 100 according to the first embodiment, the side surface of the substrate 110 is not obliquely ground, which makes it possible to reduce a problem caused when the side surface of the substrate 110 is obliquely ground.

First, it is possible to suppress a defect that may occur on the side line and the plurality of pads during the grinding process. In case that the grinding process is performed on edges of the first and second substrates by using the grinder, the plurality of pads and the side lines disposed on the upper and lower portions of the substrate are partially removed together with the substrate, which causes a problem in which the side lines and the plurality of pads are disconnected. In addition, there occurs a problem in which cracks begin to be formed in the ground side surface and propagate. Therefore, in the display device 100 according to the first embodiment, the grinding process is not performed on the side surface of the substrate 110, which may suppress a defect that may occur on the side lines 140 and the plurality of pads PAD.

In addition, the side insulation layer 150, which covers the plurality of side lines 140, may be coated by applying it from a bottom of the substrate 110 and filling it in a direction of (i.e. in direction within the plane of) the side surface to the upper surface of the substrate 110. For this reason, in case that the side surface of the substrate is obliquely ground, the side insulation layer may not be uniformly formed on the side surface of the substrate because of an inclined surface formed on the side surface of the substrate. For this reason, the side insulation layer may not be filled at a partial point without covering a part of the upper surface of the substrate or covering the entire side surface. For this reason, when the side line is exposed at the point at which the side insulation layer is not filled, there may occur a problem in which external light is reflected by the plurality of side lines at the corresponding point, or light emitted from light-emitting element is reflected by the plurality of side lines, and the light is visually recognized by the user. Therefore, in the display device 100 according to the first embodiment, an inclined surface is not formed on the side surface of the substrate 110 by the grinding process. Therefore, the side insulation layer 150 may be uniformly disposed on the side surface of the substrate 110, which makes it possible to suppress the reflection of external light by the side line 140 at the point at which the side insulation layer 150 is not filled.

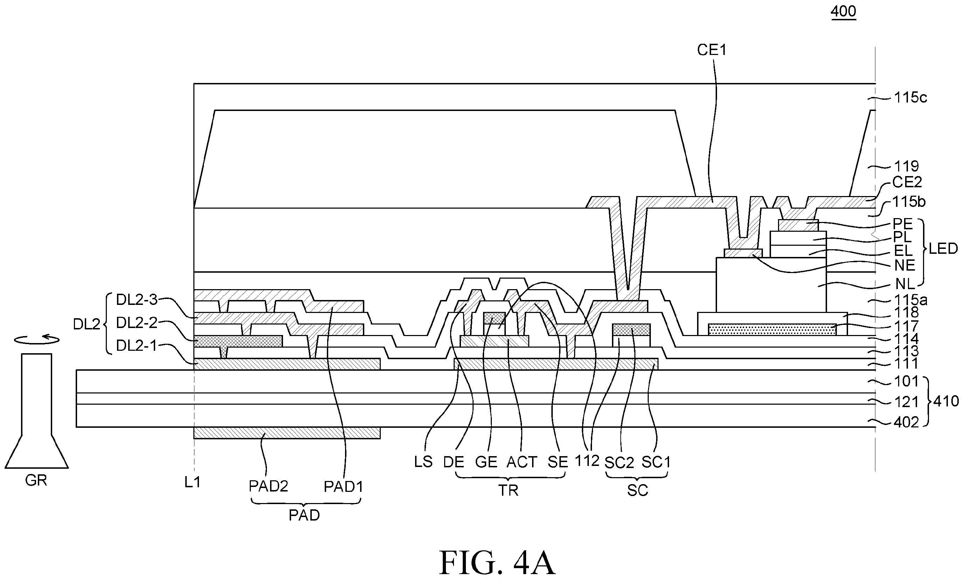

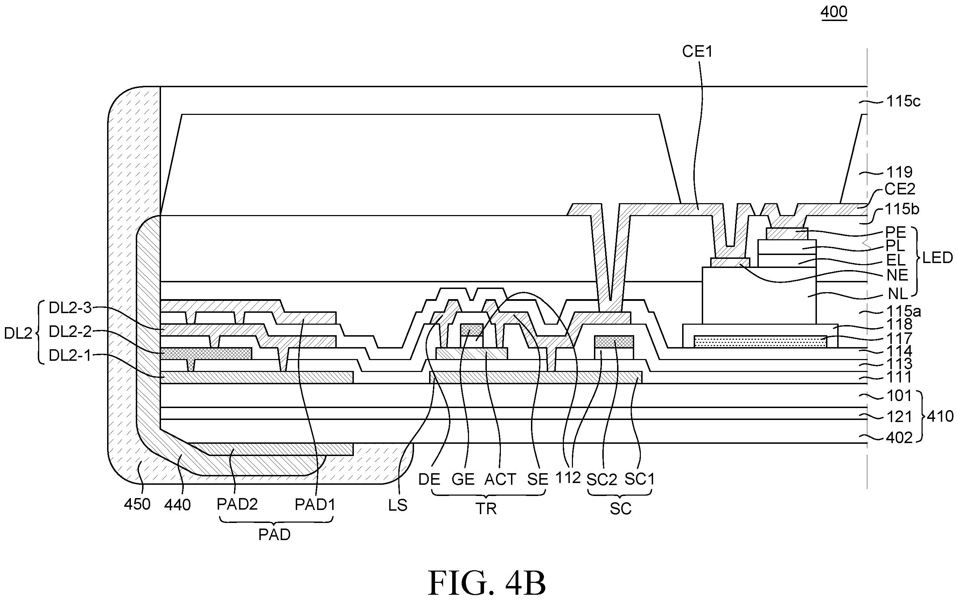

FIG. 4A is a schematic cross-sectional view of a display device in a state made before a process of grinding the display device according to a second embodiment. FIG. 4B is a schematic cross-sectional view of the display device according to the second embodiment. Because a display device 400 according to the second embodiment is substantially identical to the display device 100 according to the first embodiment, except for a substrate 410, a plurality of side lines 440, and a plurality of pads PAD, a repeated description of components, features and arrangements described with reference to FIG.s 1, 2A, 2B, 3A and 3B will be omitted.

With reference to FIG. 4A, the side surfaces of the first and second substrates 101 and 402 may be ground. The grinder GR may grind the side surfaces of the first and second substrates 101 and 402 while moving to the first line L1. Therefore, ground surfaces may be formed on the side surfaces of the first and second substrate 101 and 402 by the grinder GR. In this case, the ground surface of the first substrate 101 formed by the grinder GR may be formed straight in accordance with the shape of the grinder GR. Meanwhile, the side surface of the second substrate 402 and the side surface of the first substrate 101 may be configured as different surfaces (e.g., wherein the planes of said surfaces have differing orientations).

Hereinafter, the side surfaces of the first and second substrates 101 and 402 will be described below with reference to FIG. 4B.

With reference to FIG. 4B, the substrate 410 of the display device 400 may include the side surface formed as an inclined surface inclined with respect to an upper surface of the substrate 410. That is, a part of the side surface of the substrate 410 may be an (obliquely) inclined surface inclined with respect to the upper surface of the substrate 410.

First, the side surface of the first substrate 101 of the display device 400 is disposed on the same plane as the side surfaces of the constituent elements of the display device 400 that are disposed on an upper portion of the substrate 410. For example, the side surface of the first substrate 101 may be disposed on the same plane as the side surfaces of the plurality of signal lines and the plurality of upper pads PAD1 and disposed on the same plane as the side surfaces of the plurality of insulation layers disposed on the first substrate 101. In this case, the side surface of the first substrate 101 may be a surface perpendicular to the upper surface of the substrate 110.

The side surface of the second substrate 402 may include a side surface disposed in a direction (i.e. orientation) different from a direction (i.e. orientation) of the side surfaces of the constituent elements of the display device 400 that are disposed on the upper portion of the substrate 410. For example, a part of the side surface of the second substrate 402 may include an (obliquely) inclined surface inclined with respect to the upper surface of the substrate 110.

Meanwhile, the side surface of each of the plurality of lower pads PAD2 and the plurality of link lines disposed on the lower portion of the second substrate 402 may include an inclined surface formed at the same angle (and in the same plane) as the side surface of the second substrate 402. Therefore, as illustrated in FIG. 4B, ends of the plurality of lower pads PAD2 and the plurality of link lines disposed on the lower portion of the second substrate 402 may be disposed inward of an end of the substrate 410 (i.e., the end demarcated by the line L1).

Next, the plurality of side lines 440 is disposed on the side surfaces of the first and second substrates 101 and 402. The plurality of side lines 440 may connect the plurality of upper pads PAD1, which has the straight side surfaces, and the plurality of lower pads PAD2 including the side surfaces having the inclined surfaces. In this case, the plurality of side lines 440 may be in contact with the side surface of the first substrate 101 and the inclined side surface of the second substrate 402. Therefore, in case that the plurality of lower pads PAD2 is disposed inward of the side surface of the second substrate 402, the plurality of side lines 440 may also be in contact with a lower surface of the substrate 410.

A side insulation layer 450 is disposed to cover the plurality of side lines 440. The side insulation layer 450 may be formed to cover the side line 440 on the upper portion of the first substrate 101, the side surface of the first substrate 101, the side surface of the second substrate 402, and the lower portion of the second substrate 402. In other words, the side insulation layer 450 may cover the upper, lower and side surfaces the side lines 440. The side insulation layer 450 may protect the plurality of side lines 440.

In the display device 400 according to the second embodiment, the each of the pads PAD is disposed to overlap with at least one of the signal lines and/or at least one of the transistors TR, thereby reducing the bezel area of the display device 400.

In addition, in the display device 400 according to the second embodiment, the side surface of the substrate 410 may be disposed as the (obliquely) inclined surface, thereby reducing contact resistance between the side lines 440 the plurality of pads PAD. In case that the side surface of the substrate 410 is disposed obliquely, contact areas between the plurality of pads PAD and the plurality of side lines 440 may increase. Therefore, overall resistance of the plurality of signal lines and the plurality of pads PAD may be reduced.

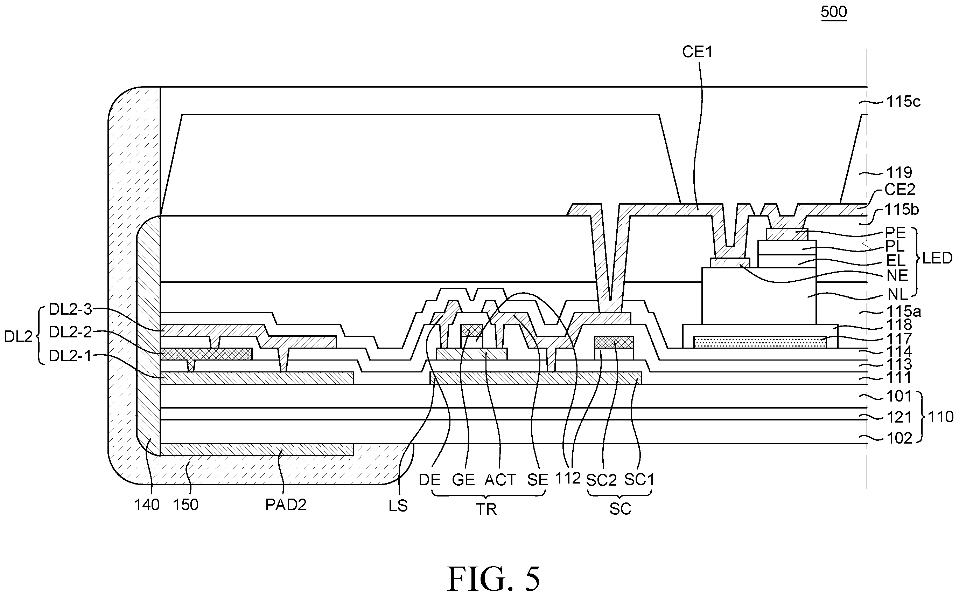

FIG. 5 is a schematic cross-sectional view of a display device according to a third embodiment. Because a display device 500 according to the third embodiment is substantially identical to the display device 100 according to the first embodiment, except for a plurality of side lines and a plurality of pads PAD, a repeated description of components, features and arrangements described with reference to FIG.s 1, 2A, 2B, 3A and 3B will be omitted.

With reference to FIG. 5, the plurality of signal lines is disposed on the first substrate 101 and disposed at an end of the first substrate 101. For convenience of description, FIG. 5 illustrates a second data line DL2 among the plurality of signal lines.

The second data line DL2 may include a first layer DL2-1, a second layer DL2-2, and a third layer DL2-3. The first layer DL2-1, the second layer DL2-2, and the third layer DL2-3 are identical to the first layer DL2-1, the second layer DL2-2, and the third layer DL2-3 described with reference to FIGs. 1 to 3B.

The passivation layer 114 and the first planarization layer 115a are disposed on the third layer DL2-3.

Meanwhile, at least one of the first layer DL2-1, the second layer DL2-2, and the third layer DL2-3, which constitute the second data line DL2, may be electrically connected to the plurality of lower pads PAD2 through the side line 140 and supply various types of signals to the plurality of subpixels SP. Therefore, at least one of the first layer DL2-1, the second layer DL2-2, and the third layer DL2-3, which constitute the second data line DL2, may be referred to as an upper pad, and each pad of a plurality of upper pads may be a part of a corresponding signal line.

In the display device 500 according to the third embodiment, the plurality of side lines 140 may be formed without obliquely grinding the side surface of the substrate 110, thereby simplifying the manufacturing process.

In addition, in the display device 500 according to the third embodiment, the side surface of the substrate 110 is not obliquely ground. Therefore, it is possible to suppress a problem in which some of the side line 140 and the plurality of pads PAD are removed, and the side line 140 and the plurality of pads PAD are disconnected during the grinding process.

In addition, in the display device 500 according to the third embodiment, an inclined surface is not formed on the side surface of the substrate 110 by the grinding process. Therefore, the side insulation layer 150 may be uniformly disposed on the side surface of the substrate 110, which makes it possible to suppress the reflection of external light by the side line 140. Alternatively, the display device 500 may be configured as the display device described with reference to FIG.s 4A and 4B (i.e. with the obliquely inclined surface of the second substrate) but without the upper pads and instead with the direct connection between the side lines 140 and one or more layers of the signal lines DL2-1, DL2-2, DL2-3 as described above with reference to FIG. 5.

In addition, in the display device 500 according to the third embodiment, some of the plurality of signal lines may be used as pads without disposing a separate pad at the end of the display device 500. In display device 500 according to the third embodiment, the plurality of side lines 140 may be in contact with the side surfaces of the plurality of signal lines. Therefore, it is possible to transmit signals, which are applied from the drive part to the plurality of pixels SP without disposing a conductive material for constituting the pad. Therefore, in the display device 500 according to the third embodiment, a separate process of forming the conductive material for constituting the pad is not performed, thereby reducing costs and simplifying the process of manufacturing the display device.

Embodiments may also be described as follows:
According to an aspect of the present disclosure, the display device includes: a substrate on which a plurality of light-emitting elements is disposed; a transistor on the substrate; a plurality of signal lines on the substrate; a plurality of link lines below the substrate; and a plurality of upper pads on the substrate and connected to the plurality of signal lines, in which the plurality of upper pads is disposed to overlap with at least one of the plurality of signal lines and the plurality of transistors.

The display device may further include a plurality of side lines which may connect the plurality of signal lines and the plurality of link lines. The plurality of upper pads and the plurality of signal lines may be in contact with the plurality of side lines.

Side surfaces of the plurality of upper pads may be disposed on the same plane as side surfaces of the plurality of signal lines.

The plurality of side lines may be in contact with a side surface and a lower surface of the substrate.

The display device may further include a plurality of lower pads on the lower surface of the substrate and connected to the plurality of link lines. The plurality of lower pads may be disposed to overlap with the plurality of upper pads.

A part of the side surface of the substrate may be an inclined surface inclined with respect to an upper surface of the substrate, and the plurality of side lines may partially cover the side surface and the lower surface of the substrate.

The substrate may include a first substrate, and a second substrate below the first substrate. A part of a side surface of the second substrate may be an inclined surface inclined with respect to the upper surface of the substrate.

The display device may further include a plurality of lower pads on the lower surface of the substrate and connected to the plurality of link lines. Ends of the plurality of lower pads may be disposed inward of an end of the substrate.

The display device may further include a plurality of insulation layers on the substrate and disposed on upper portions or lower portions of the plurality of upper pads and the plurality of signal lines. Side surfaces of the plurality of insulation layers may be disposed on the same plane as a side surface of the substrate.

The side surfaces of the plurality of insulation layers may be disposed on the same plane as side surfaces of the plurality of upper pads.

Each of the plurality of upper pads may be a part of each of the plurality of signal lines.

The display device may further include an electrostatic discharge circuit on the substrate to overlap with the plurality of upper pads.

Although embodiments have been described in detail with reference to the accompanying drawings, the present disclosure is not limited thereto and may be embodied in many different forms. Therefore, the embodiments are provided for illustrative purposes only but not intended to limit the present disclosure. Therefore, it should be understood that the above-described embodiments are illustrative in all aspects and do not limit the present disclosure. The scope of the present disclosure should be construed based on the following claims, and equivalents thereof.

Also described herein are the following numbered examples:
Example 1. A display device comprising:
   a substrate on which a plurality of light-emitting elements is disposed;
   a plurality of transistors disposed on the substrate;
   a plurality of signal lines disposed on the substrate;
   a plurality of link lines disposed below the substrate; and
   a plurality of upper pads disposed on the substrate and connected to the plurality of signal lines,
   wherein the plurality of upper pads overlaps with at least one of the plurality of signal lines and the plurality of transistors.
Example 2. The display device of example 1, further comprising a plurality of side lines connecting the plurality of signal lines and the plurality of link lines,
   wherein the plurality of upper pads and the plurality of signal lines are in contact with the plurality of side lines.
Example 3. The display device of example 1 or 2, wherein side surfaces of the plurality of upper pads are disposed on a same plane as side surfaces of the plurality of signal lines.
Example 4. The display device of example 1, 2 or 3, wherein the plurality of side lines is in contact with a side surface and a lower surface of the substrate.
Example 5. The display device of example 4, further comprising a plurality of lower pads on the lower surface of the substrate and connected to the plurality of link lines,
   wherein the plurality of lower pads overlaps with the plurality of upper pads.
Example 6. The display device of example 4 or 5, wherein a part of the side surface of the substrate is an inclined surface inclined with respect to an upper surface of the substrate, and
   wherein the plurality of side lines partially covers the side surface and the lower surface of the substrate.
Example 7. The display device of any preceding example, wherein the substrate comprises a first substrate and a second substrate below the first substrate, and
   wherein a part of a side surface of the second substrate is an inclined surface inclined with respect to the upper surface of the second substrate.
Example 8. The display device of any preceding example, further comprising a plurality of lower pads on the lower surface of the substrate and connected to the plurality of link lines,
   wherein ends of the plurality of lower pads are disposed inward of an end of the substrate.
Example 9. The display device of any preceding example, further comprising a plurality of insulation layers on the substrate and disposed on upper portions or lower portions of the plurality of upper pads and the plurality of signal lines,
   wherein side surfaces of the plurality of insulation layers are disposed on a same plane as a side surface of the substrate.
Example 10. The display device of example 9, wherein the side surfaces of the plurality of insulation layers are disposed on a same plane as side surfaces of the plurality of upper pads.
Example 11. The display device of any preceding example, wherein each of the plurality of upper pads is a part of each of the plurality of signal lines.
Example 12. The display device of any preceding example, further comprising an electrostatic discharge circuit disposed on the substrate and overlapping with the plurality of upper pads.
Example 13. A display device comprising:
   a plurality of scan lines and a plurality of data lines disposed on a first substrate;
   a light-emitting element disposed between adjacent data lines among the plurality of data lines;
   a transistor disposed on the first substrate;
   a plurality of upper pads disposed on the first substrate and connected to the plurality of scan lines and the plurality of data lines; and
   a plurality of lower pads disposed on a second substrate and overlapping with the plurality of upper pads; and
   a plurality of side lines disposed on side surfaces of the first and second substrates and connecting the plurality of upper pads, the plurality of lower pads and the plurality of data lines.
Example 14. The display device of example 13, further comprising a plurality of insulation layers disposed on the plurality of signal lines and the plurality of lower pads.
Example 15. The display device of example 14, wherein side surfaces of the plurality of insulation layers are disposed on a same plane as a side surface of the first and second substrates.
Example 16. The display device of any of examples 13-15, wherein the second substrate has a side surface that is inclined with respect to the second substrate.
Example 17. The display device of any of examples 13-16, wherein the plurality of lower pads has an end portion disposed inside an end of the second substrate.
Example 18. The display device of any of examples 13-17, wherein the plurality of upper pads has side surfaces disposed on a same plane as side surfaces of the plurality of data lines.
Example 19. The display device of any of examples 13-18, wherein the plurality of side lines are formed by a pad printing method using conductive ink.
Example 20. The display device of any of examples 13-16, further comprising an electrostatic discharge circuit disposed on the first substrate and overlapping with the plurality of upper pads.

Also described herein are the following numbered clauses:
Clause 1. A display device comprising:
   a substrate;
   a plurality of light-emitting elements disposed on the substrate;
   a plurality of transistors disposed on the substrate;
   a plurality of signal lines disposed on the substrate, each signal line electrically connected to one or more of the transistors;
   an electrostatic discharge circuit disposed on the substrate and arranged to selectively connect the signal lines to a ground line.
Clause 2. The display device of clause 1, further comprising:
   a plurality of link lines disposed under the substrate; and
   a plurality of side lines disposed on a side surface of the substrate, each side line providing at least a portion of an electrical connection between a corresponding one of the link lines and a corresponding one of the signal lines,
   wherein the electrostatic discharge circuit is electrically connected to the signal line via the side line.
Clause 3. The display device of clause 1 or 2, further comprising an upper pad disposed on the substrate, wherein the electrostatic discharge circuit overlaps with the upper pad.
Clause 4. The display device of clause 1, 2, or 3, further comprising a lower pad disposed under the substrate, wherein the electrostatic discharge circuit overlaps with the lower pad.
Clause 5. The display device of any of clauses 1 or 2, further comprising an upper pad disposed on the substrate and a lower pad disposed under the substrate, wherein the upper pad overlaps the lower pad, optionally wherein the electrostatic discharge circuit overlaps the upper pad and/or the lower pad.
Clause 6. The display device of any preceding clause, further comprising a bank disposed on the substrate, wherein the bank overlaps the electrostatic discharge circuit.
Clause 7. The display device of clause 6, wherein the bank comprises a light blocking material.
Clause 8. The display device of clause 7, wherein the bank comprises a black material.
Clause 9. The display device of any preceding clause, wherein each of the light-emitting elements is a microLED including an inorganic active layer.
Clause 10. The display device of any preceding clause, wherein each of the light-emitting elements includes:
   an n-type layer;
   an active layer on the n-type layer;
   a p-type layer on the active layer;
   an n-electrode on the n-type layer; and
   a p-electrode on the p-type layer,
   wherein the p-electrode and the n-electrode are disposed to be spaced apart from each other at different height levels.
Clause 11. The display device of clause 10, further comprising:
   a first electrode connected to the n-electrode; and
   a second electrode connected to the p-electrode.
Clause 12. The display device of clause 11, further comprising:
   a first planarization layer;
   a second planarization layer on the first planarization layer; and
   a third planarization layer on the second planarization layer,
   wherein the first electrode and the second electrode are spaced apart from each other and the third planarization layer is disposed between the first electrode and second electrode.
Clause 13. The display device of clause 12, wherein the second planarization layer and the third planarization layer are in contact with each other in an area between the first electrode and the second electrode.
Clause 14. The display device of any of clauses 11-13, further comprising:
   a bank on the first electrode and the second electrode, and
   a plurality of upper pads disposed on the substrate,
   wherein the bank overlaps at least a portion of at least one of the upper pads, optionally wherein the bank includes a light blocking material, optionally wherein the light blocking material is a black material.
Clause 15. The display device of any of clauses 9-14, further comprising a reflective layer corresponding to each of the light-emitting elements, wherein the light-emitting elements overlap the reflective layers.
Clause 16. The display device of any previous clause, further comprising a plurality of upper pads disposed on the substrate, wherein the electrostatic discharge circuit is disposed in an area between the upper pads and a display area in which the light-emitting elements are disposed.
Clause 17. The display device of any preceding clause, wherein each of the signal lines comprises at least two overlapping signal line layers connected in parallel to each other.
Clause 18. The display device of any preceding clause, further comprising a first insulating layer disposed between each of an adjacent pair of the at least two overlapping signal line layers.
Clause 19. The display device of clause 18, wherein the first insulating layer comprises first through holes which receive corresponding connecting portions connecting the adjacent pair.
Clause 20. The display device of any preceding clause, wherein the signal line is electrically connected to the upper pad, optionally wherein the signal line is electrically connected in parallel to the upper pad.
Clause 21. The display device of any preceding clause, further comprising a second insulating layer disposed between the upper pad and the signal line.
Clause 22. The display device of clause 21, wherein the second insulating layer comprises a second through hole which receives a connecting portion connecting the signal line and the upper pad.
Clause 23. The display device of any preceding clause, further comprising a plurality of upper pads disposed on the substrate, wherein each of the upper pads overlaps with:
   one of the signal lines; and/or
   one of the transistors.
Clause 24. The display device of any preceding clause, wherein an edge of the display device comprises at least one planar surface, and
   the substrate, the electrostatic discharge circuit and the signal lines terminate at the at least one planar surface.
Clause 25. The display device of clause 24, wherein the at least one planar surface comprises a first planar surface arranged perpendicular to the upper surface of the substrate.
Clause 26. The display device of clause 24 or 25, wherein the at least one planar surface comprises a second planar surface obliquely inclined relative to the upper surface of the substrate.
Clause 27. The display device of clause 24, 25 or 26, further comprising a plurality of side lines, wherein the plurality of side lines partially covers the at least one planar surface and, optionally, a lower surface of the substrate.
Clause 28. The display device of clause 28, wherein each side line is in contact with a corresponding one of the signal lines and the electrostatic discharge circuit.
Also described herein are the following numbered items:
Item 1. A display device comprising:
   a substrate;
   a plurality of light-emitting elements disposed on the substrate;
   a plurality of transistors disposed on the substrate;
   a plurality of signal lines disposed on the substrate, each signal line electrically connected to one or more of the transistors;
   an upper pad disposed on the substrate, wherein the upper pad is disposed at an edge region of the substrate,
   a bank disposed on the upper pad to overlap the upper pad.
Item 2. The display device of item 1, further comprising a plurality of lower pads disposed under the substrate, wherein the upper pads overlap the lower pads.
Item 3. The display device of item 1 or 2, wherein the bank includes light blocking material, optionally a black material.
Item 4. The display device of any preceding item, wherein the bank extends to the edge of the substrate.
Item 5. The display device of any preceding item, wherein the bank extends between the edge of the substrate and the light-emitting elements.
Item 6. The display device of any preceding item, wherein each of the signal lines comprises at least two overlapping signal line layers connected in parallel to each other.
Item 7. The display device of item 6, further comprising a first insulating layer disposed between each of an adjacent pair of the at least two overlapping signal line layers.
Item 8. The display device of item 7, wherein the first insulating layer comprises first through holes which receive corresponding connecting portions connecting the adjacent pair.
Item 9. The display device of any preceding item, wherein the signal line is electrically connected to the upper pad, optionally wherein the signal line is electrically connected in parallel to the upper pad.
Item 10. The display device of any preceding item, further comprising a second insulating layer disposed between the upper pad and the signal line.
Item 11. The display device of item 10, wherein the second insulating layer comprises a second through hole which receives a connecting portion connecting the signal line and the upper pad.
Item 12. The display device of any preceding item, wherein each of the light-emitting elements is a microLED including an inorganic active layer.
Item 13. The display device of any preceding item, wherein each of the light-emitting elements includes:
   an n-type layer;
   an active layer on the n-type layer;
   a p-type layer on the active layer;
   an n-electrode on the n-type layer; and
   a p-electrode on the p-type layer,
   wherein the p-electrode and the n-electrode are disposed to be spaced apart from each other at different height levels.
Item 14. The display device of item 13, further comprising:
   a first electrode connected to the n-electrode; and
   a second electrode connected to the p-electrode.
Item 15. The display device of item 14, further comprising:
   a first planarization layer;
   a second planarization layer on the first planarization layer; and
   a third planarization layer on the second planarization layer,
   wherein the first electrode and the second electrode are spaced apart from each other and the third planarization layer is disposed between the first electrode and second electrode.
Item 16. The display device of item 15, wherein the second planarization layer and the third planarization layer are in contact with each other in an area between the first electrode and the second electrode.
Item 17. The display device of any of items 14-16, wherein the bank is disposed on the first electrode and the second electrode.
Item 18. The display device of any preceding item, further comprising a reflective layer corresponding to each of the light-emitting elements, wherein the light-emitting elements overlap the reflective layers.
Item 19. The display device of any preceding item, further comprising an electrostatic discharge circuit disposed on the substrate and arranged to selectively electrically connect the signal lines to a ground line, wherein the bank is disposed on the electrostatic discharge circuit and overlaps the electrostatic discharge circuit.
Item 20. The display device of any preceding item, wherein the bank is disposed to overlap the plurality of signal lines.
Item 21. The display device of any preceding item, wherein an edge of the display device comprises at least one planar surface, and
   the substrate and the signal lines terminate at the at least one planar surface.
Item 22. The display device of item 21, wherein the at least one planar surface comprises a first planar surface arranged perpendicular to the upper surface of the substrate.
Item 23. The display device of item 21 or 22, wherein the at least one planar surface comprises a second planar surface obliquely inclined relative to the upper surface of the substrate.
Item 24. The display device of item 21, 22 or 23, further comprising a plurality of side lines, wherein the plurality of side lines partially covers the at least one planar surface and, optionally, a lower surface of the substrate.
Item 25. The display device of item 24, wherein each side line is in contact with a corresponding one of the signal lines.
Also described herein are the following numbered embodiments:
Embodiment 1. A display device comprising:
   a substrate;
   a plurality of light-emitting elements disposed on the substrate;
   a plurality of transistors disposed on the substrate;
   a plurality of signal lines disposed on the substrate, each signal line electrically connected to one or more of the transistors;
   a plurality of link lines disposed below the substrate; and
   a plurality of side lines disposed on a side surface of the substrate, each side line providing at least a portion of an electrical connection between a corresponding one of the link lines and a corresponding one of the signal lines.
Embodiment 2. The display device of embodiment 1, wherein an edge of the display device comprises at least one planar surface, and
   the substrate and the signal lines terminate at the at least one planar surface.
Embodiment 3. The display device of embodiment 2, wherein the at least one planar surface comprises a first planar surface arranged perpendicular to the upper surface of the substrate.
Embodiment 4. The display device of embodiment 2 or 3, wherein the at least one planar surface comprises a second planar surface obliquely inclined relative to the upper surface of the substrate.
Embodiment 5. The display device of embodiment 2, 3 or 4, wherein the plurality of side lines partially covers the at least one planar surface and, optionally, a lower surface of the substrate.
Embodiment 6. The display device of any preceding embodiment, wherein each side line is in contact with a corresponding one of the signal lines.
Embodiment 7. The display device of any preceding embodiment, wherein the substrate comprises a first substrate and a second substrate below the first substrate, and
   wherein at least part of a side surface of the second substrate forms at least a part of the second planar surface.
Embodiment 8. The display device of any preceding embodiment, further comprising a plurality of upper pads disposed on the substrate, each upper pad electrically connected to a corresponding one of the signal lines.
Embodiment 9. The display device of any preceding embodiment, further comprising a plurality of upper pads disposed on the substrate,
   wherein the each of the subpixels comprises a transistor, and
   wherein each of the upper pads overlaps with:
      one of the signal lines; and/or
      one of the transistors.
Embodiment 10. The display device of embodiments 8 or 9,
   wherein each side line is in contact with a corresponding one of the upper pads.
Embodiment 11. The display device of any of embodiments 8, 9 or 10, wherein a side surface of the upper pads is in a same plane as a side surface of the signal lines.
Embodiment 12. The display device of any of embodiments 8-11, further comprising a plurality of lower pads on the lower surface of the substrate, each lower pad electrically connected to a corresponding one of the link lines,
   wherein each of the lower pads overlaps with a corresponding one of the upper pads.
Embodiment 13. The display device of any of embodiments 8-12, further comprising a plurality of insulation layers on the substrate and disposed on upper portions or lower portions of:
   the plurality of upper pads; and/or
   the plurality of signal lines,
   wherein side surfaces of the insulation layers are in a same plane as a side surface of the substrate.
Embodiment 14. The display device of embodiment 13, wherein the side surfaces of the insulation layers are in a same plane as side surfaces of the upper pads and/or side surfaces of the signal lines.
Embodiment 15. The display device of any of embodiments 8-14, wherein each of the upper pads is a part of a corresponding one of the signal lines.
Embodiment 16. The display device of any of embodiments 8-15, further comprising an electrostatic discharge circuit disposed on the substrate and overlapping with the plurality of upper pads.
Embodiment 17. The display device of any preceding embodiment, further comprising a plurality of lower pads on the lower surface of the substrate, each lower pad electrically connected to a corresponding one of the link lines,
   wherein ends of the lower pads are disposed inward of an end of the substrate.
Embodiment 18. The display device of any preceding embodiment, further comprising:
   a plurality of upper pads disposed on the substrate, each upper pad connected to a corresponding one of the signal lines; and
   a plurality of lower pads disposed below the substrate, each lower pad overlapping with a corresponding one of the upper pads,
   wherein the side lines electrically connect the lower pads to:
      the upper pads; and/or
      the plurality of signal lines.
Embodiment 19. The display of any preceding embodiment, further comprising a side insulation layer disposed to cover the plurality of side lines, optionally wherein the side insulation layer comprises a light blocking material.
Embodiment 20. The display device of any preceding embodiment, wherein each of the signal lines comprises at least two overlapping signal line layers connected in parallel to each other.
Embodiment 21. The display device of any preceding embodiment, further comprising a first insulating layer disposed between each of an adjacent pair of the at least two overlapping signal line layers.
Embodiment 22. The display device of embodiment 21, wherein the first insulating layer comprises first through holes which receive corresponding connecting portions connecting the adjacent pair.
Embodiment 23. The display device of any preceding embodiment, further comprising a plurality of upper pads, wherein each signal line is electrically connected to a corresponding upper pad, optionally in parallel to the corresponding upper pad.
Embodiment 24. The display device of any preceding embodiment, further comprising a second insulating layer disposed between the upper pad and the signal line, wherein the second insulating layer comprises a second through hole which receives a connecting portion connecting the signal line and the upper pad.
Embodiment 25. The display device of any preceding embodiment, further comprising a bank disposed on the substrate, optionally wherein the bank comprises a light blocking material, optionally a black material.
Embodiment 26. The display device of any preceding embodiment, wherein each of the plurality of light-emitting elements is a microLED including an inorganic active layer.
Embodiment 27. The display device of any preceding embodiment, wherein each of the light-emitting elements includes:
   an n-type layer;
   an active layer on the n-type layer;
   a p-type layer on the active layer;
   an n-electrode on the n-type layer; and
   a p-electrode on the p-type layer,
   wherein the p-electrode and the n-electrode are disposed to be spaced apart from each other at different height levels.
Embodiment 28. The display device of embodiment 27, further comprising:
   a first electrode connected to the n-electrode; and
   a second electrode connected to the p-electrode.
Embodiment 29. The display device of embodiment 28, further comprising:
   a first planarization layer;
   a second planarization layer on the first planarization layer; and
   a third planarization layer on the second planarization layer,
   wherein the first electrode and the second electrode are spaced apart from each other and the third planarization layer is disposed between the first electrode and second electrode.
Embodiment 30. The display device of embodiment 29, wherein the second planarization layer and the third planarization layer are in contact with each other in an area between the first electrode and the second electrode.
Embodiment 31. The display device of any of embodiments 28-30, further comprising:
   a bank on the first electrode and the second electrode, and
   a plurality of upper pads disposed on the substrate,
   wherein the bank overlaps at least a portion of at least one of the upper pads, optionally wherein the bank includes a light blocking material, optionally wherein the light blocking material is a black material.
Embodiment 32. The display device of any of embodiments 26-31, further comprising a reflective layer corresponding to each of the light-emitting elements, wherein the light-emitting elements overlap the reflective layers.
Embodiment 33. The display device of any previous embodiment, further comprising:
   an electrostatic discharge circuit disposed on the substrate and arranged to selectively connect the signal lines to a ground line, and
   wherein the electrostatic discharge circuit is electrically connected to the signal line via the side line,
   optionally wherein the electrostatic discharge circuit is disposed in an area between the upper pads and a display area in which the light-emitting elements are disposed.
Embodiment 34. A method of manufacturing a display device comprising:
   providing a display panel comprising: a substrate; a plurality of subpixels disposed on the substrate; a plurality of signal lines disposed on the substrate, each signal line electrically connected to one or more of the subpixels; a plurality of link lines disposed below the substrate, wherein a portion of the substrate protrudes beyond an end of the plurality of signal lines,
   removing at least the portion of the substrate to provide a planar side surface of the display panel comprising a side surface of the substrate and a side surface of each of the signal lines in the same plane as the side surface of the substrate;
   depositing a plurality of side lines on the side surface of the display panel.
Embodiment 35. The method of embodiment 34, wherein depositing a plurality of side lines comprises depositing the plurality of side lines by pad-printing a conductive ink.
Embodiment 36. The method of embodiment 34 or 35, wherein the removing at least the portion of the substrate, comprises grinding the protruding portion of the substrate, optionally further comprising grinding the substrate other than the protruding portion, optionally further comprising grinding the signal lines.
Embodiment 37. The method of embodiment 34 or 35, further comprising removing an end portion of the substrate other than the protruding portion, optionally further comprising removing an end portion of the signal lines.

## Claims

1. A display device comprising:
a substrate;
a plurality of light-emitting elements disposed on the substrate;
a plurality of transistors disposed on the substrate;
a plurality of signal lines disposed on the substrate;
a plurality of link lines disposed below the substrate; and
a plurality of upper pads disposed on the substrate, wherein each of the upper pads overlaps with one of the signal lines and/or one of the transistors.

2. The display device of claim 1, wherein an edge of the display device comprises a planar surface, and
the substrate and the signal lines terminate at the planar surface.

3. The display device of claim 1 or 2, further comprising a plurality of side lines disposed on a side surface of the substrate, each side line providing at least a portion of an electrical connection between a corresponding one of the link lines and a corresponding one of the signal lines.

4. The display device of claim 3, wherein the side lines are in contact with a side surface of the substrate and, optionally, a lower surface of the substrate.

5. The display device of claim 3 or 4, further comprising:
a plurality of lower pads disposed under the substrate, each lower pad overlapping with a corresponding one of the upper pads,
wherein the side lines electrically connect the lower pads to:
the upper pads; and/or
the signal lines.

6. The display of any of claims 3-5, further comprising a side insulation layer disposed to cover the plurality of side lines, optionally wherein the side insulation layer comprises a light blocking material, optionally a black material.

7. The display device of any of claims 3-6, wherein a part of the side surface of the substrate is an inclined surface obliquely inclined with respect to an upper surface of the substrate, and
wherein the plurality of side lines partially covers the side surface and, optionally, the lower surface of the substrate.

8. The display device of claim 7, wherein the substrate comprises a first substrate and a second substrate below the first substrate, and
wherein at least part of a side surface of the second substrate forms at least a part of the inclined surface.

9. The display device of any of claims 3-8,
wherein each side line is in contact with:
a corresponding one of the upper pads, and/or
a corresponding one of the signal lines.

10. The display device of any preceding claim, wherein each upper pad is electrically connected to a corresponding one of the signal lines, and/or wherein a side surface of the upper pads is in a same plane as a side surface of the signal lines.

11. The display device of any preceding claim, further comprising a plurality of lower pads on the lower surface of the substrate, each lower pad electrically connected to a corresponding one of the link lines,
wherein each of the lower pads overlaps with a corresponding one of the upper pads, and/or
wherein ends of the lower pads are disposed inward of an end of the substrate.

12. The display device of claim, further comprising a plurality of insulation layers on the substrate and disposed on upper portions or lower portions of:
the upper pads; and/or
the signal lines,
wherein side surfaces of the insulation layers are in a same plane as a side surface of the substrate and/or side surfaces of the upper pads.

13. The display device of any preceding claim, wherein each of the light-emitting elements is a microLED including an inorganic active layer, and/or
wherein each of the light-emitting elements includes:
an n-type layer;
an active layer on the n-type layer;
a p-type layer on the active layer;
an n-electrode on the n-type layer; and
a p-electrode on the p-type layer,
wherein the p-electrode and the n-electrode are disposed to be spaced apart from each other at different height levels.

14. The display device of claim 13, further comprising:
a first electrode connected to the n-electrode; and
a second electrode connected to the p-electrode.

15. The display device of claim 14, further comprising:
a first planarization layer;
a second planarization layer on the first planarization layer; and
a third planarization layer on the second planarization layer,
wherein the first electrode and the second electrode are spaced apart from each other and the third planarization layer is disposed between the first electrode and second electrode,
optionally wherein the second planarization layer and the third planarization layer are in contact with each other in an area between the first electrode and the second electrode.

16. The display device of claim 14 or 15, further comprising a bank on the first electrode and the second electrode,
wherein the bank overlaps at least a portion of at least one of the upper pads, optionally wherein the bank includes a light blocking material,
optionally wherein the light blocking material is a black material.

17. The display device of any of claims 13-16, further comprising a reflective layer corresponding to each of the light-emitting elements, wherein the light-emitting elements overlap the reflective layers.

18. The display device of any preceding claim, further comprising an electrostatic discharge circuit disposed on the substrate and arranged to selectively connect the signal lines to a ground line,
wherein the electrostatic discharge circuit is disposed in an area between the plurality of upper pads and a display area in which a plurality of subpixels are disposed, or
wherein the electrostatic discharge circuit overlaps the plurality of upper pads.

19. The display device of any preceding claim, wherein each of the signal lines comprises at least two overlapping signal line layers connected in parallel to each other,
optionally wherein the display device further comprises an insulating layer disposed between each of an adjacent pair of the at least two overlapping signal line layers,
wherein the insulating layer comprises through holes which receive corresponding connecting portions electrically connecting the adjacent pair.

20. The display device of any preceding claim, wherein each signal line is electrically connected in parallel to a corresponding upper pad,
optionally wherein the display device further comprises an insulating layer disposed between the upper pad and the signal line,
wherein the insulating layer comprises a through hole which receives a connecting portion electrically connecting the signal line and the upper pad.

## Amended claims

### Amended claims in accordance with Rule 137(2) EPC.

1. A display device (100) comprising:
a substrate (110);
a plurality of light-emitting elements (LED) disposed on the substrate;
a plurality of transistors (TR) disposed on the substrate;
a plurality of signal lines (DL) disposed on the substrate;
a plurality of link lines disposed below the substrate; and
a plurality of upper pads (PAD1) disposed on the substrate, wherein each of the upper pads overlaps with one of the signal lines and/or one of the transistors,
wherein each of the signal lines comprises at least two overlapping signal line layers (DL2-1, DL2-2, DL2-3) connected in parallel to each other,
wherein the display device further comprises an insulating layer (113) disposed between each of an adjacent pair of the at least two overlapping signal line layers,
wherein the insulating layer comprises through holes which receive corresponding connecting portions electrically connecting the adjacent pair.

2. The display device of claim 1, wherein an edge of the display device comprises a planar surface, and
the substrate and the signal lines terminate at the planar surface.

3. The display device of claim 1 or 2, further comprising a plurality of side lines disposed on a side surface of the substrate, each side line providing at least a portion of an electrical connection between a corresponding one of the link lines and a corresponding one of the signal lines.

4. The display device of claim 3, wherein the side lines are in contact with a side surface of the substrate and, optionally, a lower surface of the substrate.

5. The display device of claim 3 or 4, further comprising:
a plurality of lower pads (PAD2) disposed under the substrate, each lower pad overlapping with a corresponding one of the upper pads,
wherein the side lines electrically connect the lower pads to:
the upper pads; and/or
the signal lines.

6. The display of any of claims 3-5, further comprising a side insulation layer (150) disposed to cover the plurality of side lines, optionally wherein the side insulation layer comprises a light blocking material, optionally a black material.

7. The display device of any of claims 3-6, wherein a part of the side surface of the substrate is an inclined surface obliquely inclined with respect to an upper surface of the substrate, and
wherein the plurality of side lines partially covers the side surface and, optionally, the lower surface of the substrate.

8. The display device of claim 7, wherein the substrate comprises a first substrate (101) and a second substrate (102) below the first substrate, and
wherein at least part of a side surface of the second substrate forms at least a part of the inclined surface.

9. The display device of any of claims 3-8,
wherein each side line is in contact with:
a corresponding one of the upper pads, and/or
a corresponding one of the signal lines.

10. The display device of any preceding claim, wherein each upper pad is electrically connected to a corresponding one of the signal lines, and/or wherein a side surface of the upper pads is in a same plane as a side surface of the signal lines.

11. The display device of any preceding claim, further comprising a plurality of lower pads on the lower surface of the substrate, each lower pad electrically connected to a corresponding one of the link lines,
wherein each of the lower pads overlaps with a corresponding one of the upper pads, and/or
wherein ends of the lower pads are disposed inward of an end of the substrate.

12. The display device of any preceding claim, further comprising a plurality of insulation layers on the substrate and disposed on upper portions or lower portions of:
the upper pads; and/or
the signal lines,
wherein side surfaces of the insulation layers are in a same plane as a side surface of the substrate and/or side surfaces of the upper pads.

13. The display device of any preceding claim, wherein each of the light-emitting elements is a microLED including an inorganic active layer, and/or
wherein each of the light-emitting elements includes:
an n-type layer;
an active layer on the n-type layer;
a p-type layer on the active layer;
an n-electrode on the n-type layer; and
a p-electrode on the p-type layer,
wherein the p-electrode and the n-electrode are disposed to be spaced apart from each other at different height levels.

14. The display device of claim 13, further comprising:
a first electrode connected to the n-electrode; and
a second electrode connected to the p-electrode.

15. The display device of claim 14, further comprising:
a first planarization layer (115a);
a second planarization layer (115b) on the first planarization layer; and
a third planarization layer (115c) on the second planarization layer,
wherein the first electrode and the second electrode are spaced apart from each other and the third planarization layer is disposed between the first electrode and second electrode,
optionally wherein the second planarization layer and the third planarization layer are in contact with each other in an area between the first electrode and the second electrode.

16. The display device of claim 14 or 15, further comprising a bank (119) on the first electrode and the second electrode,
wherein the bank overlaps at least a portion of at least one of the upper pads, optionally wherein the bank includes a light blocking material,
optionally wherein the light blocking material is a black material.

17. The display device of any of claims 13-16, further comprising a reflective layer (117) corresponding to each of the light-emitting elements, wherein the light-emitting elements overlap the reflective layers.

18. The display device of any preceding claim, further comprising an electrostatic discharge circuit disposed on the substrate and arranged to selectively connect the signal lines to a ground line,
wherein the electrostatic discharge circuit is disposed in an area between the plurality of upper pads and a display area in which a plurality of subpixels are disposed, or
wherein the electrostatic discharge circuit overlaps the plurality of upper pads.

19. The display device of any preceding claim, wherein each signal line is electrically connected in parallel to a corresponding upper pad,
optionally wherein the display device further comprises an insulating layer disposed between the upper pad and the signal line,
wherein the insulating layer comprises a through hole which receives a connecting portion electrically connecting the signal line and the upper pad.
